# EUROPEAN PATENT APPLICATION

(11) **EP 4 557 372 A1**
(43) Date of publication of application: **21.05.2025**
(21) Application number: 23839498.5
(22) Date of filing: 30.06.2023
(51) Int. Cl.: H01L 27/146, H04N 25/70

(54) **LIGHT DETECTION APPARATUS**

(30) Priority: 14.07.2022 JP 2022112817
(71) Applicant: Sony Semiconductor Solutions Corporation, Atsugi-shi, Kanagawa 243-0014 (JP)
(72) Inventor: MIYANAMI, Yuki, Atsugi-shi, Kanagawa 243-0014 (JP); NISHIO, Kenya, Kikuchi-gun, Kumamoto 869-1102 (JP); SAITO, Suguru, Atsugi-shi, Kanagawa 243-0014 (JP); YOSHIDA, Shinichi, Atsugi-shi, Kanagawa 243-0014 (JP); ENOMOTO, Takayuki, Atsugi-shi, Kanagawa 243-0014 (JP); KUBO, Shinji, Kikuchi-gun, Kumamoto 869-1102 (JP); WATANABE, Kyonosuke, Atsugi-shi, Kanagawa 243-0014 (JP); HIRAMATSU, Katsunori, Atsugi-shi, Kanagawa 243-0014 (JP); HAYASHI, Toshihiko, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/024506
(87) International publication number: WO 2024/014326

(57) **Abstract**

A first imaging device according to an embodiment of the disclosure includes: a semiconductor substrate having opposing first and second surfaces, and including pixels arranged in matrix; photoelectric conversion sections formed to be embedded in the semiconductor substrate for the respective pixels and generating electric charge corresponding to a received light amount by photoelectric conversion; floating diffusion layers provided on the first surface between the adjacent pixels, and temporarily holding the electric charge generated in the photoelectric conversion sections provided for the respective adjacent pixels; a first groove part provided to surround the pixels sharing the floating diffusion layer and penetrating from the first surface to the second surface; a second groove part provided above at least the floating diffusion layers, stretching from the second surface toward the first surface, and having a bottom in the semiconductor substrate; and an oxide film provided in contact with the bottom.

## Description

### Technical Field

The present disclosure relates to a photodetector in which, for example, a floating diffusion layer is shared by a plurality of pixels.

### Background Art

For example, PTL 1 discloses an imaging element in which a through trench is provided between pixels each including a photoelectric conversion section.

### Citation List

### Patent Literature

PTL 1: Japanese Unexamined Patent Application Publication No. 2019-145544

### Summary of the Invention

Incidentally, it is desired for a photodetector applied to an imaging device, for example, to have improved performance.

It is desirable to provide a photodetector that makes it possible to improve performance.

A first photodetector according to an embodiment of the present disclosure includes: a semiconductor substrate having a first surface and a second surfaces opposed to each other, the semiconductor substrate including a plurality of pixels arranged in matrix; a plurality of photoelectric conversion sections formed to be embedded in the semiconductor substrate for the respective pixels and generating electric charge corresponding to a received light amount by photoelectric conversion; a plurality of floating diffusion layers provided on the first surface of the semiconductor substrate between the plurality of pixels adjacent to each other, the plurality of floating diffusion layers temporarily holding the electric charge generated in the plurality of photoelectric conversion sections provided for the respective pixels adjacent to each other; a first groove part provided to surround the plurality of pixels sharing corresponding one of the floating diffusion layers and penetrating from the first surface of the semiconductor substrate to the second surface; a second groove part provided above at least the plurality of floating diffusion layers and stretching from the second surface of the semiconductor substrate toward the first surface, the second groove part having a bottom in the semiconductor substrate; and an oxide film provided in contact with the bottom of the second groove part.

According to the first photodetector of an embodiment of the present disclosure, in the semiconductor substrate including the plurality of pixels arranged in matrix and being provided with the floating diffusion layer on the first surface between the plurality of pixels adjacent to each other, the first groove part penetrating from the first surface of the semiconductor substrate to the second surface is provided around the plurality of pixels sharing the floating diffusion layer; the second groove part stretching from the second surface of the semiconductor substrate toward the first surface and having a bottom in the semiconductor substrate is provided above at least the floating diffusion layer; and the oxide film is provided in contact with the bottom of the second groove part. This reduces dispersion of a distance between the floating diffusion layer and the bottom of the second groove part.

A second photodetector according to an embodiment of the present disclosure includes: a semiconductor substrate having a first surface and a second surfaces opposed to each other, the semiconductor substrate including a plurality of pixels arranged in matrix; a plurality of photoelectric conversion sections formed to be embedded in the semiconductor substrate for the respective pixels and generating electric charge corresponding to a received light amount by photoelectric conversion; a plurality of floating diffusion layers provided on the first surface of the semiconductor substrate between the plurality of pixels adjacent to each other, the plurality of floating diffusion layers temporarily holding the electric charge generated in the plurality of photoelectric conversion sections provided for the respective pixels adjacent to each other; a first groove part provided to surround the plurality of pixels sharing corresponding one of the floating diffusion layers and penetrating from the first surface of the semiconductor substrate to the second surface, the first groove part having an inner wall on which a first pinning film is formed; and a second groove part provided above at least the plurality of floating diffusion layers and stretching from the second surface of the semiconductor substrate toward the first surface, the second groove part having a bottom in the semiconductor substrate and having an inner wall on which a second pinning film is formed, the second pinning film having weaker pinning than the first pinning film.

According to the second photodetector of an embodiment of the present disclosure, in the semiconductor substrate including the plurality of pixels arranged in matrix and being provided with the floating diffusion layer on the first surface between the plurality of pixels adjacent to each other, the first groove part penetrating from the first surface of the semiconductor substrate to the second surface is provided around the plurality of pixels sharing the floating diffusion layer; and the first pinning film is provided on the inner wall thereof. In addition, the second groove part stretching from the second surface of the semiconductor substrate toward the first surface and having the bottom in the semiconductor substrate is provided above at least the floating diffusion layer, and the second pinning film having weaker pinning than the first pinning film is provided on the inner wall of the second groove part. This reduces pinning on the floating diffusion layer.

A third photodetector according to an embodiment of the present disclosure includes: a semiconductor substrate having a first surface and a second surfaces opposed to each other, the semiconductor substrate including a plurality of pixels arranged in matrix; a plurality of photoelectric conversion sections formed to be embedded in the semiconductor substrate for the respective pixels and generating electric charge corresponding to a received light amount by photoelectric conversion; a first separation section provided between the plurality of pixels adjacent to each other and stretching from the second surface of the semiconductor substrate toward the first surface, the first separation section having a bottom in the semiconductor substrate; and a second separation section provided between the bottom of the first separation section and the first surface, the second separation section having a wider width on a side of the bottom of a groove part than on a side of the first surface.

According to the third photodetector of an embodiment of the present disclosure, in the semiconductor substrate including the plurality of pixels arranged in matrix, the first separation section stretching from the second surface of the semiconductor substrate toward the first surface and having the bottom in the semiconductor substrate is provided between the plurality of pixels adjacent to each other; and the second separation section having a wider width on the side of the bottom of the groove part than on the side of the first surface is provided between the bottom of the first separation section and the first surface. This secures an element formation region of the first surface of the semiconductor substrate.

### Brief Description of the Drawings

[FIG. 1] FIG. 1 is a schematic cross-sectional view of an example of a configuration of a photodetector according to a first embodiment of the present disclosure.
[FIG. 2] FIG. 2 is a block diagram illustrating an overall configuration of the photodetector illustrated in FIG. 1.
[FIG. 3] FIG. 3 is an equivalent circuit diagram of a unit pixel illustrated in FIG. 1.
[FIG. 4A] FIG. 4A is a schematic view of an example of a planar configuration of the photodetector illustrated in FIG. 1.
[FIG. 4B] FIG. 4B is a schematic view of another example of the planar configuration of the photodetector illustrated in FIG. 1.
[FIG. 5A] FIG. 5A is a schematic view of another example of a cross-sectional shape of an oxide film illustrated in FIG. 1.
[FIG. 5B] FIG. 5B is a schematic view of another example of the cross-sectional shape of the oxide film illustrated in FIG. 1
[FIG. 5C] FIG. 5C is a schematic view of another example of the cross-sectional shape of the oxide film illustrated in FIG. 1.
[FIG. 5D] FIG. 5D is a schematic view of another example of the cross-sectional shape of the oxide film illustrated in FIG. 1.
[FIG. 6A] FIG. 6A is an explanatory schematic cross-sectional view of a method of manufacturing the photodetector illustrated in FIG. 1.
[FIG. 6B] FIG. 6B is a schematic cross-sectional view of a step subsequent to FIG. 6A.
[FIG. 6C] FIG. 6C is a schematic cross-sectional view of a step subsequent to FIG. 6B.
[FIG. 6D] FIG. 6D is a schematic cross-sectional view of a step subsequent to FIG. 6C.
[FIG. 6E] FIG. 6E is a schematic cross-sectional view of a step subsequent to FIG. 6D.
[FIG. 6F] FIG. 6F is a schematic cross-sectional view of a step subsequent to FIG. 6E.
[FIG. 6G] FIG. 6G is a schematic cross-sectional view of a step subsequent to FIG. 6F.
[FIG. 6H] FIG. 6H is a schematic cross-sectional view of a step subsequent to FIG. 6G.
[FIG. 7] FIG. 7 is a schematic cross-sectional view of an example of a configuration of a photodetector according to Modification Example 1 of a the present disclosure.
[FIG. 8] FIG. 8 is a schematic cross-sectional view of an example of a configuration of a photodetector according to a second embodiment of the present disclosure.
[FIG. 9] FIG. 9 is a schematic view of an example of a planar configuration of a photodetector according to Modification Example 2 of the present disclosure.
[FIG. 10] FIG. 10 is a schematic cross-sectional view of an example of a configuration of a photodetector according to Modification Example 3 of the present disclosure.
[FIG. 11] FIG. 11 is a schematic cross-sectional view of an example of a configuration of a photodetector according to a third embodiment of the present disclosure.
[FIG. 12A] FIG. 12A is an explanatory schematic cross-sectional view of the method of manufacturing the photodetector illustrated in FIG. 11.
[FIG. 12B] FIG. 12B is a schematic cross-sectional view of a step subsequent to FIG. 12A.
[FIG. 12C] FIG. 12C is a schematic cross-sectional view of a step subsequent to FIG. 12B.
[FIG. 12D] FIG. 12D is a schematic cross-sectional view of a step subsequent to FIG. 12C.
[FIG. 13] FIG. 13 is a schematic cross-sectional view of an example of a configuration of a photodetector according to Modification Example 4 of the present disclosure.
[FIG. 14A] FIG. 14A is an explanatory schematic cross-sectional view of a method of manufacturing the photodetector illustrated in FIG. 13.
[FIG. 14B] FIG. 14B is a schematic cross-sectional view of a step subsequent to FIG. 14A.
[FIG. 14C] FIG. 14C is a schematic cross-sectional view of a step subsequent to FIG. 14B.
[FIG. 15] FIG. 15 is a schematic cross-sectional view of an example of a configuration of a photodetector according to a fourth embodiment of the present disclosure.
[FIG. 16A] FIG. 16A is an explanatory schematic cross-sectional view of a method of manufacturing the photodetector illustrated in FIG. 15.
[FIG. 16B] FIG. 16B is a schematic cross-sectional view of a step subsequent to FIG. 16A.
[FIG. 16C] FIG. 16C is a schematic cross-sectional view of a step subsequent to FIG. 16B.
[FIG. 17A] FIG. 17A is an explanatory schematic plane view of a method of manufacturing the photodetector illustrated in FIG. 15.
[FIG. 17B] FIG. 17B is a schematic plan view of a step subsequent to FIG. 17A.
[FIG. 17C] FIG. 17C is a schematic plan view of a step subsequent to FIG. 17B.
[FIG. 17D] FIG. 17D is a schematic plan view of a step subsequent to FIG. 17C.
[FIG. 18] FIG. 18 is a schematic view of an example of a planar configuration of a photodetector according to Modification Example 5 of the present disclosure.
[FIG. 19] FIG. 19 is a schematic cross-sectional view of an example of a configuration of a photodetector according to a fifth embodiment of the present disclosure.
[FIG. 20A] FIG. 20A is a schematic view of an example of a planar configuration of the photodetector illustrated in FIG. 19.
[FIG. 20B] FIG. 20B is a schematic view of another example of the planar configuration of the photodetector illustrated in FIG. 19.
[FIG. 21] FIG. 21 is a schematic cross-sectional view of another example of the configuration of the photodetector according to the fifth embodiment of the present disclosure.
[FIG. 22A] FIG. 22A is an explanatory schematic cross-sectional view of a method of manufacturing the photodetector illustrated in FIG. 21.
[FIG. 22B] FIG. 22B is a schematic cross-sectional view of a step subsequent to FIG. 22A.
[FIG. 22C] FIG. 22C is a schematic cross-sectional view of a step subsequent to FIG. 22B.
[FIG. 22D] FIG. 22D is a schematic cross-sectional view of a step subsequent to FIG. 22C.
[FIG. 22E] FIG. 22E is a schematic cross-sectional view of a step subsequent to FIG. 22D.
[FIG. 23A] FIG. 23A is an explanatory schematic plan view of the step illustrated in FIG. 22C.
[FIG. 23B] FIG. 23B is a schematic view of an example of a cross-sectional shape of an increased width section.
[FIG. 23C] FIG. 23C is a schematic view of another example of the cross-sectional shape of the increased width section.
[FIG. 23D] FIG. 23D is a schematic view of another example of the cross-sectional shape of the increased width section.
[FIG. 24] FIG. 24 is a schematic cross-sectional view of an example of a configuration of a photodetector according to Modification Example 6 of the present disclosure.
[FIG. 25] FIG. 25 is a schematic cross-sectional view of an example of a configuration of a photodetector according to Modification Example 7 of the present disclosure.
[FIG. 26] FIG. 26 is a schematic view of an example of a planar configuration of the photodetector illustrated in FIG. 25.
[FIG. 27] FIG. 27 is a block diagram illustrating an example of a configuration of an electronic apparatus using the photodetector illustrated in FIG. 2.
[FIG. 28A] FIG. 28A is a schematic view of an example of an overall configuration of a photodetection system using the photodetector illustrated in FIG. 2.
[FIG. 28B] FIG. 28B is a diagram illustrating an example of a circuit configuration of the photodetection system illustrated in FIG. 28A.
[FIG. 29] FIG. 29 is a view depicting an example of a schematic configuration of an endoscopic surgery system.
[FIG. 30] FIG. 30 is a block diagram depicting an example of a functional configuration of a camera head and a camera control unit (CCU).
[FIG. 31] FIG. 31 is a block diagram depicting an example of schematic configuration of a vehicle control system.
[FIG. 32] FIG. 32 is a diagram of assistance in explaining an example of installation positions of an outside-vehicle information detecting section and an imaging section.
[FIG. 33] FIG. 33 is a schematic cross-sectional view of an example of a configuration of a photodetector according to a sixth embodiment of the present disclosure.
[FIG. 34] FIG. 34 is a schematic view of an example of a planar configuration corresponding to a line A-A in the photodetector illustrated in FIG. 33.
[FIG. 35] FIG. 35 is a schematic view of an example of a planar configuration corresponding to a line B-B in the photodetector illustrated in FIG. 33.
[FIG. 36A] FIG. 36A is a schematic view of an example of a planar configuration corresponding to a line C-C in the photodetector illustrated in FIG. 33.
[FIG. 36B] FIG. 36B is a schematic view of another example of the planar configuration corresponding to the line C-C in the photodetector illustrated in FIG. 33.
[FIG. 37A] FIG. 37A is an explanatory schematic cross-sectional view of an example of a method of manufacturing an element separation section illustrated in FIG. 33.
[FIG. 37B] FIG. 37B is a schematic cross-sectional view of a step subsequent to FIG. 37A.
[FIG. 37C] FIG. 37C is a schematic cross-sectional view of a step subsequent to FIG. 37B.
[FIG. 37D] FIG. 37D is a schematic cross-sectional view of a step subsequent to FIG. 37C.
[FIG. 37E] FIG. 37E is a schematic cross-sectional view of a step subsequent to FIG. 37D.
[FIG. 37F] FIG. 37F is a schematic cross-sectional view of a step subsequent to FIG. 37E.
[FIG. 37G] FIG. 37G is a schematic cross-sectional view of a step subsequent to FIG. 37F.
[FIG. 37H] FIG. 37H is a schematic cross-sectional view of a step subsequent to FIG. 37G.
[FIG. 38A] FIG. 38A is an explanatory schematic cross-sectional view of another example of the method of manufacturing the element separation section illustrated in FIG. 33.
[FIG. 38B] FIG. 38B is a schematic cross-sectional view of a step subsequent to FIG. 38A.
[FIG. 38C] FIG. 38C is a schematic cross-sectional view of a step subsequent to FIG. 38B.
[FIG. 38D] FIG. 38D is a schematic cross-sectional view of a step subsequent to FIG. 38C.
[FIG. 38E] FIG. 38E is a schematic cross-sectional view of a step subsequent to FIG. 38D.
[FIG. 38F] FIG. 38F is a schematic cross-sectional view of a step subsequent to FIG. 38E.
[FIG. 38G] FIG. 38G is a schematic cross-sectional view of a step subsequent to FIG. 38F.
[FIG. 39] FIG. 39 is a schematic cross-sectional view of another example of the configuration of the photodetector according to the sixth embodiment of the present disclosure.
[FIG. 40] FIG. 40 is a schematic cross-sectional view of an example of a configuration of a photodetector according to Modification Example 8 of the present disclosure.
[FIG. 41] FIG. 41 is a schematic view of an example of a planar configuration corresponding to a line A-A in the photodetector illustrated in FIG. 40.
[FIG. 42] FIG. 42 is a schematic view of an example of a planar configuration corresponding to a line B-B in the photodetector illustrated in FIG. 40.
[FIG. 43] FIG. 43 is a schematic view of an example of a planar configuration corresponding to a line C-C in the photodetector illustrated in FIG. 40.
[FIG. 44A] FIG. 44A is an explanatory schematic cross-sectional view of an example of a method of manufacturing an element separation section illustrated in FIG. 40.
[FIG. 44B] FIG. 44B is a schematic cross-sectional view of a step subsequent to FIG. 44A.
[FIG. 44C] FIG. 44C is a schematic cross-sectional view of a step subsequent to FIG. 44B.

### Modes for Carrying Out the Invention

In the following, description is given of embodiments of the present disclosure in detail with reference to the drawings. The following description is merely a specific example of the present disclosure, and the present disclosure should not be limited to the following aspects. Moreover, the present disclosure is not limited to arrangements, dimensions, dimensional ratios, and the like of each component illustrated in the drawings. It is to be noted that the description is given in the following order.
1. First Embodiment (An example of a photodetector including an oxide film at a bottom of a separation section provided above an FD.
2. Modification Example 1 (An example in which a p-type diffusion region is provided on an outer wall of the separation section)
3. Second Embodiment (An example of a photodetector including an etching inhibition layer at a bottom of the separation section provided above the FD)
4. Modification Example 2 (Another example of a position where the etching inhibition layer is formed)
5. Modification Example 3 (Another example of the position where the etching inhibition layer is formed)
6. Third Embodiment (An example of a photodetector in which a pinning film is formed on an inner wall of the separation section provided above the FD and exposed to the bottom, with the pinning film being weaker than a pinning film provided on another separation section)
7. Modification Example 4 (An example of a photodetector in which the bottom of the separation section provided above the FD is made free from pinning)
8. Fourth Embodiment (An example of a photodetector in which a pinning film is formed on an inner wall of the separation section provided above the FD, with the pinning film being weaker than a pinning film provided on another separation section)
9. Modification Example 5 (Another example of a planar shape of the separation section provided above the FD)
10. Fifth Embodiment (An example of a photodetector provided with a T-shaped element separation section)
11. Modification Example 6 (Another example of the photodetector with the T-shaped element separation section)
12. Modification Example 7 (Another example of the photodetector with the T-shaped element separation section)
13. Sixth Embodiment (An example of a photodetector having an air gap in the element separation section)
14. Modification Example 8 (Another example of the photodetector having an air gap in the element separation section)
15. Application Examples
16. Practical Application Examples

### <1. First Embodiment>

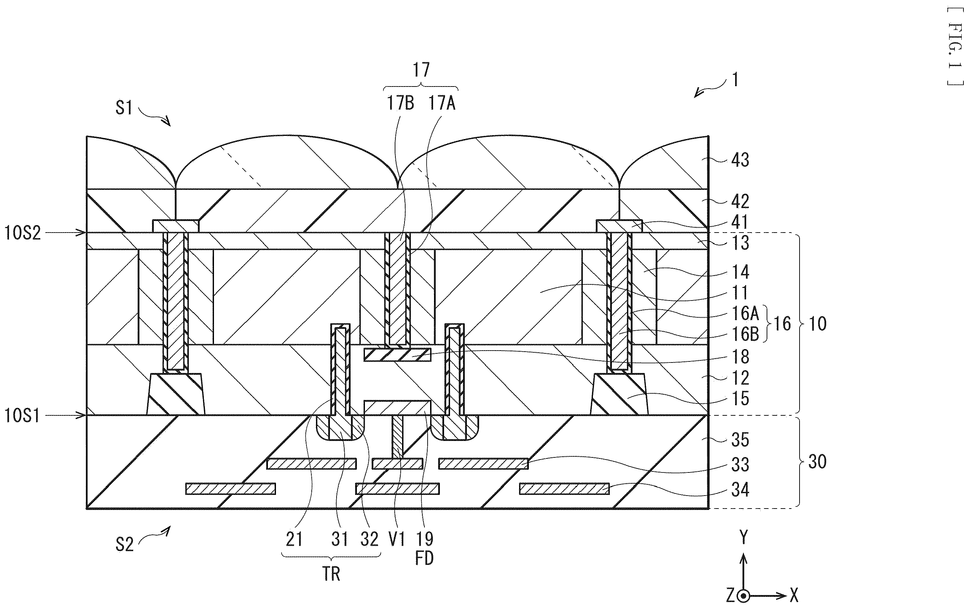

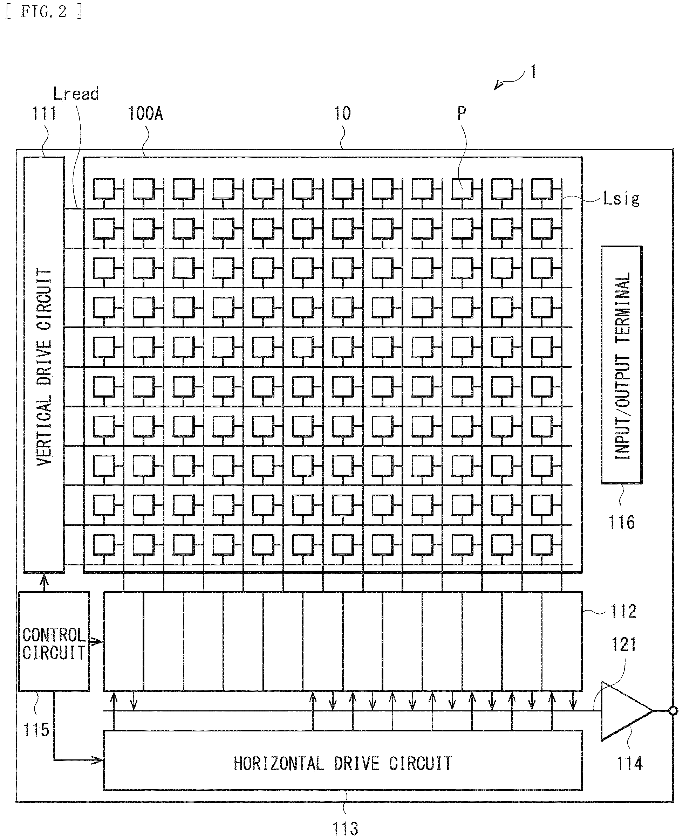

FIG. 1 schematically illustrates an example of a cross-sectional configuration of a photodetector (a photodetector 1) according to a first embodiment of the present disclosure. FIG. 2 illustrates an example of an overall configuration of the photodetector 1 illustrated in FIG. 1. The photodetector 1 is, for example, a CMOS (Complementary Metal Oxide Semiconductor) image sensor, or the like used in an electronic apparatus such as a digital still camera or a video camera, and includes, as an imaging area, a pixel section (a pixel section 100A) in which a plurality of pixels is two-dimensionally arranged in matrix. The photodetector 1 is, for example, a so-called back side illumination photodetector in this CMOS image sensor, or the like.

In the photodetector 1 according to the present embodiment, a plurality of unit pixels P is arranged in matrix. Further, in a semiconductor substrate 10 in which a floating diffusion (FD) 19 is provided on a surface (a surface 10S1) between the plurality of unit pixels P adjacent to each other, a separation section 16 is provided around an outer periphery of the plurality of unit pixels P sharing the FD 19. The separation section 16 penetrates a pair of surfaces (the surface 10S1 and a surface 10S2) opposed to each other of the semiconductor substrate 10. A separation section 17 is provided above the FD 19. The separation section 17 stretches from the surface 10S2 of the semiconductor substrate 10 toward the surface 10S1 thereof, and has a bottom in the semiconductor substrate 10. An oxide film 18 is provided at the bottom of the separation section 17.

### [Schematic Configuration of Photodetector]

FIG. 2 illustrates an example of an overall configuration of the photodetector 1.

The photodetector 1 is, for example, a CMOS image sensor. The photodetector 1 takes in incident light (image light) from a subject via an optical lens system (unillustrated), and converts the amount of incident light formed as an image on an imaging surface into electric signals in units of pixels to output the electric signals as pixel signals. The photodetector 1 includes the pixel section 100A as an imaging area on the semiconductor substrate 10. In addition, the photodetector 1 includes, for example, a vertical drive circuit 111, a column signal processing circuit 112, a horizontal drive circuit 113, an output circuit 114, a control circuit 115, and an input/output terminal 116 in a peripheral region of this pixel section 100A.

The pixel section 100A includes, for example, the plurality of unit pixels P that is two-dimensionally arranged in matrix. The unit pixels P are provided, for example, with a pixel drive line Lread (specifically, a row selection line and a reset control line) wired for each of pixel rows, and provided with a vertical signal line Lsig wired for each of pixel columns. The pixel drive line Lread transmits drive signals for reading signals from the pixels. One end of the pixel drive line Lread is coupled to an output end of the vertical drive circuit 111 corresponding to each of the rows.

The vertical drive circuit 111 is a pixel drive section that is configured by a shift register, an address decoder, and the like and drives the unit pixels P of the pixel section 100A on a row-by-row basis, for example. Signals outputted from the respective unit pixels P in the pixel rows selectively scanned by the vertical drive circuit 111 are supplied to the column signal processing circuit 112 through the respective vertical signal lines Lsig. The column signal processing circuit 112 is configured by an amplifier, a horizontal selection switch, and the like provided for each of the vertical signal lines Lsig.

The horizontal drive circuit 113 is configured by a shift register, an address decoder, and the like. The horizontal drive circuit 113 drives horizontal selection switches of the column signal processing circuit 112 in order while scanning the horizontal selection switches. The selective scanning by this horizontal drive circuit 113 causes signals of the respective pixels transmitted through the respective vertical signal lines Lsig to be outputted to a horizontal signal line 121 in order and causes the signals to be transmitted to the outside of the semiconductor substrate 10 through the horizontal signal line 121.

The output circuit 114 performs signal processing on signals sequentially supplied from the respective column signal processing circuits 112 via the horizontal signal line 121, and outputs the signals. The output circuit 114 performs, for example, only buffering in some cases, and performs black level adjustment, column variation correction, various kinds of digital signal processing, and the like in other cases.

The circuit portion including the vertical drive circuit 111, the column signal processing circuit 112, the horizontal drive circuit 113, the horizontal signal line 121, and the output circuit 114 may be formed directly on the semiconductor substrate 10, or may be provided on an external control IC. In addition, the circuit portion may be formed in another substrate coupled by a cable or the like.

The control circuit 115 receives a clock supplied from the outside of the semiconductor substrate 10, data for an instruction about an operation mode, and the like, and also outputs data such as internal information on the photodetector 1. The control circuit 115 further includes a timing generator that generates various timing signals, and controls driving of the peripheral circuits including the vertical drive circuit 111, the column signal processing circuit 112, the horizontal drive circuit 113, and the like on the basis of the various timing signals generated by the timing generator.

The input/output terminal 116 exchanges signals with the outside.

### [Circuit Configuration of Unit Pixel]

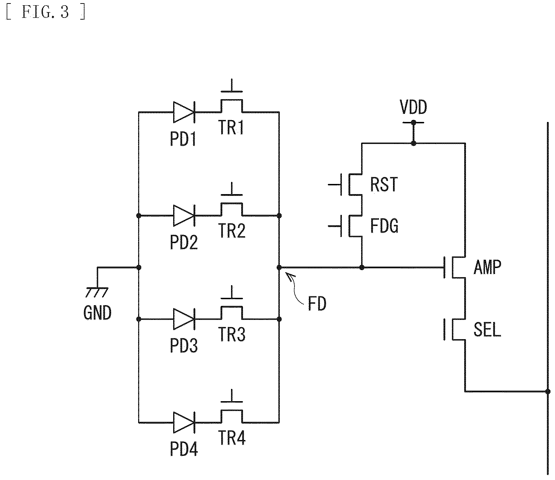

FIG. 3 illustrates an example of a readout circuit of the unit pixel P of the photodetector 1 illustrated in FIG. 1.

In the pixel section 100A, as described above, the plurality of unit pixels P is two-dimensionally arranged in matrix. More specifically, a unit cell U including the plurality of unit pixels P serves as a repeating unit, and is repeatedly arranged in an array including a row direction and a column direction. One unit cell U includes four unit pixels P, for example. The four unit pixels P share one floating diffusion FD and one readout circuit. Here, the term "share" means that outputs of the four unit pixels P are inputted to the floating diffusion FD and the readout circuit that are common.

Each unit pixel P includes mutually common components. In FIG. 3, in order to distinguish components of the unit pixels P from one another, an identification number (1, 2, 3, or 4) is assigned to the end of a symbol of the component of each unit pixel P. Hereinafter, in a case where the components of the respective unit pixels P need to be distinguished from one another, the identification number is assigned to the end of the symbol of the component of each unit pixel P; however, in a case where the components of the respective unit pixels P do not need to be distinguished from one another, the identification number at the end of the symbol of the component of each unit pixel P is omitted.

Each unit pixel P includes, for example, a photodiode PD, a transfer transistor TR electrically coupled to the photodiode PD, and a floating diffusion FD that temporarily holds electric charge outputted from the photodiode PD via the transfer transistor TR. The photodiode PD performs photoelectric conversion to generate electric charge corresponding to a received light amount. A cathode of the photodiode PD is electrically coupled to a source of the transfer transistor TR, and an anode of the photodiode PD is electrically coupled to a reference potential line (e.g., ground). A drain of the transfer transistor TR is electrically coupled to the floating diffusion FD, and a gate of the transfer transistor TR is electrically coupled to the pixel drive line Lread. The transfer transistor TR is, for example, a CMOS (Complementary Metal Oxide Semiconductor) transistor.

As described above, the floating diffusion FD shared by the four unit pixels P is electrically coupled to an input end of the common readout circuit. The readout circuit includes, for example, a reset transistor RST, a selection transistor SEL, and an amplification transistor AMP. It is to be noted that the selection transistor SEL may be omitted as needed. A source of the reset transistor RST (an input end of the readout circuit) is electrically coupled to the floating diffusion FD, and a drain of the reset transistor RST is electrically coupled to a power supply line VDD and a drain of the amplification transistor AMP. A gate of the reset transistor RST is electrically coupled to the pixel drive line Lread. A source of the amplification transistor AMP is electrically coupled to a drain of the selection transistor SEL, and a gate of the amplification transistor AMP is electrically coupled to the source of the reset transistor RST. A source of the selection transistor SEL (an output end of the readout circuit) is electrically coupled to the vertical signal line Lsig, and a gate of the selection transistor SEL is electrically coupled to the pixel drive line Lread.

When the transfer transistor TR is brought into an ON state, the transfer transistor TR transfers electric charge of the photodiode PD to the floating diffusion FD. The gate of the transfer transistor TR includes a vertical transfer gate 31, and is formed on the surface (surface 10S1) of the semiconductor substrate 10, for example, as illustrated in FIG. 1. The reset transistor RST resets a potential of the floating diffusion FD to a predetermined potential. When the reset transistor RST is brought into an ON state, the potential of the floating diffusion FD is reset to a potential of the power supply line VDD. The selection transistor SEL controls an output timing of the pixel signal from the readout circuit. The amplification transistor AMP generates, as a pixel signal, a signal of a voltage corresponding to a level of electric charge held in the floating diffusion FD. The amplification transistor AMP constitutes a source-follower type amplifier, and outputs a pixel signal of a voltage corresponding to a level of electric charge generated in the photodiode PD. When the selection transistor SEL is brought into an ON state, the amplification transistor AMP amplifies the potential of the floating diffusion FD, and outputs a voltage corresponding to the potential to the column signal processing circuit 112 via the vertical signal line Lsig. The reset transistor RST, the amplification transistor AMP, and the selection transistor SEL are each, for example, a CMOS transistor.

It is to be noted that the readout circuit may include, for example, an FD transfer transistor FDG. The FD transfer transistor FDG is provided, for example, between the source of the reset transistor RST and the gate of the amplification transistor AMP.

### [Configuration of Unit pixel]

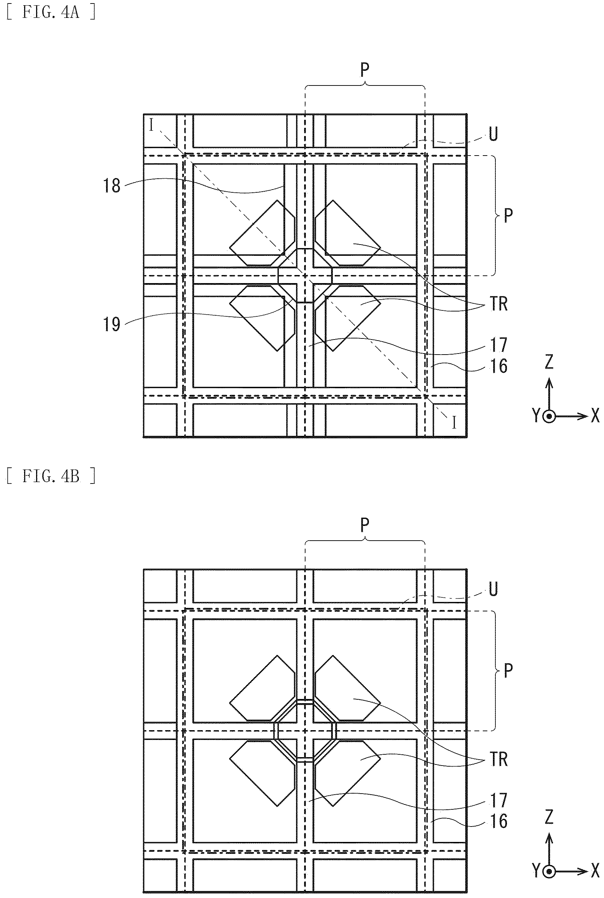

FIGs. 4A and 4B each schematically illustrate an example of a planar configuration of the photodetector 1 illustrated in FIG. 1. It is to be noted that FIG. 1 corresponds to a cross-section along a line I-I illustrated in FIG. 4A.

Description is given below of the unit pixel P by exemplifying a case of a back side illumination type; however, the present technology is also applicable to a front side illumination type.

The unit pixel P includes a photodiode (PD) 11 which is a photoelectric conversion element formed to be embedded in the semiconductor substrate 10 having the pair of surfaces (surface 10S1 and surface 10S2) opposed to each other. A p-type region 13 is formed on a light incident side S1 of the PD 11 (a side of a back surface (surface 10S2) of the semiconductor substrate 10). A p-well 12 is formed, as an active region, on a side opposite to the light incident side S1 of the PD 11 (a side of a front surface (surface 10S1) of the semiconductor substrate 10). The p-well 12 includes, for example, the FD 19, the transfer transistor TR, the pixel transistors (e.g., the reset transistor RST, the selection transistor SEL, and the amplification transistor AMP) constituting the readout circuit. The p-well 12 further includes an element separation section 15 having an STI (Shallow Trench Isolation) structure and separating the pixel transistors, and the like.

The separation sections 16 and 17 are provided between the unit pixels P adjacent to each other. The separation section 16 is provided between the unit cells U adjacent to each other. The separation section 16 constitutes an FTI (Full Trench Isolation) structure together with the element separation section 15 formed by a silicon oxide (SiOₓ) film, or the like, for example. The FTI structure penetrates from the surface 10S1 of the semiconductor substrate 10 to the surface 10S2 thereof. The separation section 17 is provided between the plurality of unit pixels P sharing the FD 19. The separation section 17 stretches from the surface 10S2 of the semiconductor substrate 10 toward the surface 10S1 thereof, and has a DTI (Deep Trench Isolation) structure having the bottom in the semiconductor substrate 10. The separation section 17 provided in the semiconductor substrate 10 includes, at the bottom, the oxide film 18 having a wider width than a width of the separation section 17, for example. An n-type diffusion region 14 is provided between the PD 11 and the separation sections 16 and 17.

The unit pixel P includes, on the light incident side S1 (a side of the surface 10S2 of the semiconductor substrate 10), a light-blocking film 41 provided between the unit pixels P adjacent to each other, a color filter 42, and an on-chip lens 43. A multilayer wiring layer 30 is provided on the surface 10S1 of the semiconductor substrate 10 on the side opposite to the light incident side S1 of the unit pixel P.

The light-blocking film 41 is directed to preventing light from leaking into an adjacent unit pixel P, and is provided between the unit pixels P adjacent to each other, specifically, at a boundary position between the color filters 42 transmitting mutually different color light beams. Examples of the constituent material of the light-blocking film 41 include an electrically-conductive material having a light-blocking property. Specific examples thereof include tungsten (W), silver (Ag), copper (Cu), aluminum (Al), and an alloy of Al and Cu.

The color filter 42 includes, for example, a red filter 42R that selectively transmits red light (R), a green filter 42G that selectively transmits green light (G), and a blue filter 42B that that selectively transmits blue light (B). As for the color filters 42R, 42G, and 42B, for example, for each of the unit cells U, four green filters 42G are arranged on a diagonal line, and the red filter 42R and the blue filter 42B are arranged one by one on the orthogonal diagonal line. In each of the unit cells U provided with the color filters 42R, 42G, and 42B, for example, corresponding color light beams are detected in a plurality of PDs 11 in the unit cell U. That is, in the pixel section 100A, the unit cells U that each detect the red light (R), the green light (G), and the blue light (B) are arrayed in a Bayer pattern.

The on-chip lens 43 condenses incident light on the PD 11, and is provided for each of the unit pixels P, for example, as illustrated in FIG. 1. The on-chip lens 43 can be formed using, for example, an inorganic material such as silicon oxide (SiOₓ) or silicon nitride (SiNₓ). In addition, the on-chip lens 43 may be formed using an organic material having a high refractive index such as an episulfide-based resin, a thiethane compound, or a resin thereof.

The multilayer wiring layer 30 is provided with, for example, the pixel transistors constituting the readout circuit. Specifically, for example, the vertical transfer gate 31 of the transfer transistor TR is provided to extend from the surface 10S1 of the semiconductor substrate 10 to such a depth as to reach the PD 11. A sidewall 32 is provided around the transfer gate 31 provided on the surface 10S1 of the semiconductor substrate 10. A sidewall and a bottom surface of the transfer gate 31 extending in the semiconductor substrate 10 are covered with an insulating film 21. In the multilayer wiring layer 30, a plurality of wiring layers 33 and a plurality of wiring layers 34 are further stacked with an interlayer insulating layer 35 interposed therebetween, and, for example, the wiring layer 33 and the FD 19 are electrically coupled to each other through a via V1. In the multilayer wiring layer 30, for example, there are formed, in addition to the readout circuit described above, the vertical drive circuit 111, the column signal processing circuit 112, the horizontal drive circuit 113, the output circuit 114, the control circuit 115, and the input/output terminal 116.

Hereinafter, description is given in detail of the separation sections 16 and 17 and the oxide film 18.

The separation section 16 corresponds to a "first groove part" of the present disclosure, and is provided between the unit cells U adjacent to each other, as described above. In other words, the separation section 16 is provided to surround an outer periphery of four unit pixels arranged, for example, in two rows and two columns sharing the FD 19, and is provided in a grid pattern in the pixel section 100A, for example, as illustrated in FIG. 4A. The separation section 16 electrically separates the adjacent unit cells U from each other, and stretches from the side of the surface 10S2 of the semiconductor substrate 10 toward a side of the surface 10S1 thereof, for example. As described above, the separation section 16 constitutes the FTI structure together with the element separation section 15 provided on the surface 10S1 of the semiconductor substrate 10. The FTI structure penetrates from the surface 10S1 of the semiconductor substrate 10 to the surface 10S2 thereof.

The separation section 16 is configured by a pinning film 16A and an insulating film 16B. The pinning film 16A is provided on an inner wall and a bottom surface of the groove that forms the separation section 16, and has positive fixed electric charge, for example. The insulating film 16B fills the groove.

Examples of the constituent material of the pinning film 16A include hafnium oxide (HfOₓ), aluminum oxide (AlOₓ), zirconium oxide (ZrOₓ), tantalum oxide (TaOₓ), titanium oxide (TiOₓ), lanthanum oxide (LaOₓ), praseodymium oxide (PrOₓ), cerium oxide (CeOₓ), neodymium oxide (NdOₓ), promethium oxide (PmOₓ), samarium oxide (SmOₓ), europium oxide (EuOₓ), gadolinium oxide (GdOₓ), terbium oxide (TbOₓ), dysprosium oxide (DyOₓ), holmium oxide (HoOₓ), thulium oxide (TmOₓ), ytterbium oxide (YbOₓ), lutetium oxide (LuOₓ), yttrium oxide (YOₓ), hafnium nitride (HfNₓ), aluminum nitride (AlNₓ), hafnium oxynitride (HfOₓN_{y}), and aluminum oxynitride (AlOₓN_{y}). The pinning film 16A may be a monolayer film, or a stacked film including different materials.

Examples of the constituent material of the insulating film 16B include a silicon oxide (SiOₓ) film.

In addition, an electrically-conductive film having a light-blocking property may be embedded inside the pinning film 16A of the groove that forms the separation section 16. Specific examples thereof include tungsten (W), silver (Ag), copper (Cu), aluminum (Al), and an alloy of Al and Cu. The electrically-conductive film may be a monolayer film, or a stacked film including different materials. Examples of the stacked film include a stacked film of Al and cobalt (Co) or a stacked film of Al and Ti constituting a so-called barrier metal. As described above, embedding the electrically-conductive film having a light-blocking property inside the pinning film 16A makes it possible to electrically and optically separate the adjacent unit cells U from each other.

The separation section 17 corresponds to a "second groove part" of the present disclosure. As described above, for example, the separation section 17 is provided between the plurality of unit pixels P sharing the FD 19, and is in contact with the separation section 16 on an outer periphery of the unit cell U. Aside from the above, for example, as illustrated in FIG. 4B, the separation section 17 may be selectively provided only above the FD 19 provided near an intersection of four unit pixels arranged, for example, in two rows and two columns that constitute the unit cell U. At that time, the separation section 16 extends from the outer periphery of the unit cell U toward the separation section 17 between the adjacent unit pixels P constituting the unit cell U, and is in contact with the separation section 17 in a vicinity of the FD 19 in a plan view. The separation section 17 electrically separates the adjacent unit pixels P from each other in the unit cell U, and stretches from the side of the surface 10S2 of the semiconductor substrate 10 toward the side of the surface 10S1 thereof, for example, as described above; the separation section 17 has the DTI structure having the bottom in the semiconductor substrate 10, specifically, at an interface or an inside of the p-well 12.

In the same manner as the separation section 16, the separation section 17 is configured by, for example, a pinning film 17A and an insulating film 17B. The pinning film 17A is provided on an inner wall and a bottom surface of the groove that forms the separation section 17, and has positive fixed electric charge, for example. The insulating film 17B fills the groove.

Examples of the constituent material of the pinning film 17A include hafnium oxide (HfOₓ), aluminum oxide (AlOₓ), zirconium oxide (ZrOₓ), tantalum oxide (TaOₓ), titanium oxide (TiOₓ), lanthanum oxide (LaOₓ), praseodymium oxide (PrOₓ), cerium oxide (CeOₓ), neodymium oxide (NdOₓ), promethium oxide (PmOₓ), samarium oxide (SmOₓ), europium oxide (EuOₓ), gadolinium oxide (GdOₓ), terbium oxide (TbOₓ), dysprosium oxide (DyOₓ), holmium oxide (HoOₓ), thulium oxide (TmOₓ), ytterbium oxide (YbOₓ), lutetium oxide (LuOₓ), yttrium oxide (YOₓ), hafnium nitride (HfNₓ), aluminum nitride (AlNₓ), hafnium oxynitride (HfOₓN_{y}), and aluminum oxynitride (AlOₓN_{y}). The pinning film 17A may be a monolayer film, or a stacked film including different materials. This pinning film 17A corresponds to a specific example of a "first pinning film" of the present disclosure.

Examples of the constituent material of the insulating film 17B include silicon oxide (SiOₓ).

In addition, an electrically-conductive film having a light-blocking property may be embedded inside the pinning film 17A of the groove that forms the separation section 17. Specific examples thereof include tungsten (W), silver (Ag), copper (Cu), aluminum (Al), and an alloy of Al and Cu. The electrically-conductive film may be a monolayer film, or a stacked film including different materials. Examples of the stacked film include a stacked film of Al and cobalt (Co) or a stacked film of Al and Ti constituting a so-called barrier metal. As described above, embedding the electrically-conductive film having a light-blocking property inside the pinning film 17A makes it possible to electrically and optically separate the adjacent unit pixels P in the unit cell U from each other.

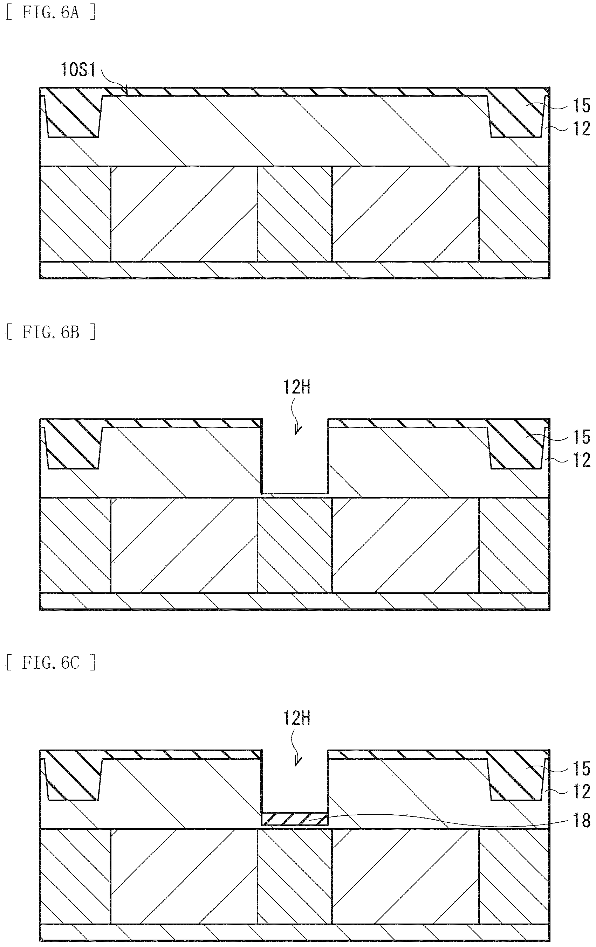

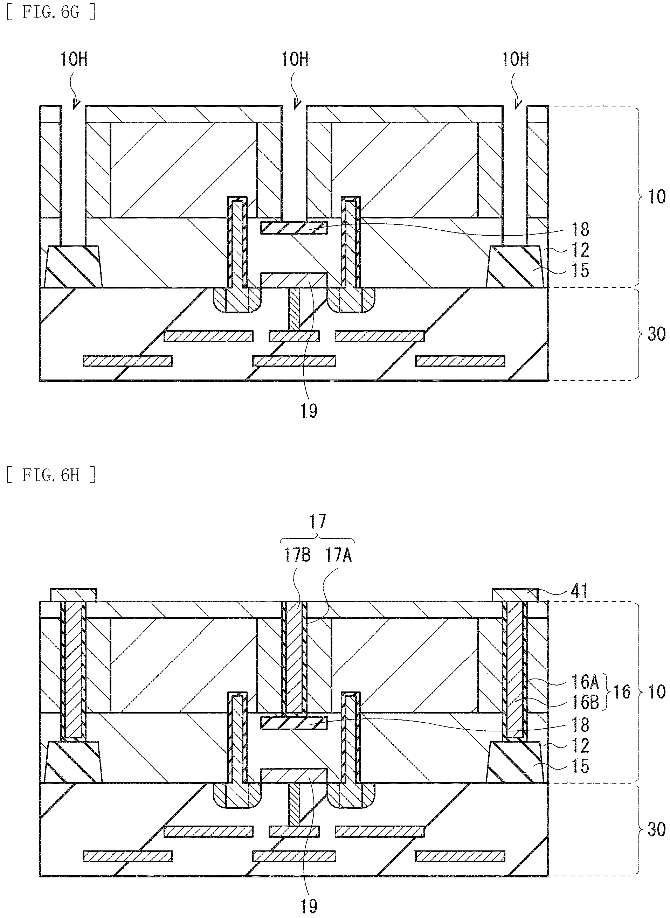

The oxide film 18 corresponds to a specific example of an "oxide film" of the present disclosure, and is provided in contact with the bottom of the separation section 17 formed at the interface or the inside of the p-well 12. In other words, the oxide film 18 is provided in contact with the bottom of the separation section 17 in the p-well 12. The oxide film 18 serves as an etching stopper film upon machining of a groove (a groove 10H, see FIG. 6G) constituting the separation section 17, and reduces dispersion of a distance between the separation section 17 and the FD 19. The oxide film 18 is provided to have a wider width than the width of the separation section 17 in an X-Z plane direction, for example, as illustrated in FIGs. 1, 4A, or other drawings.

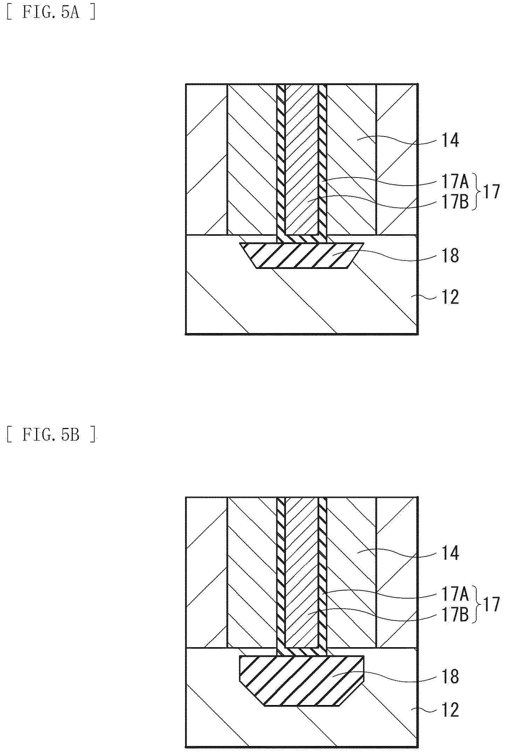

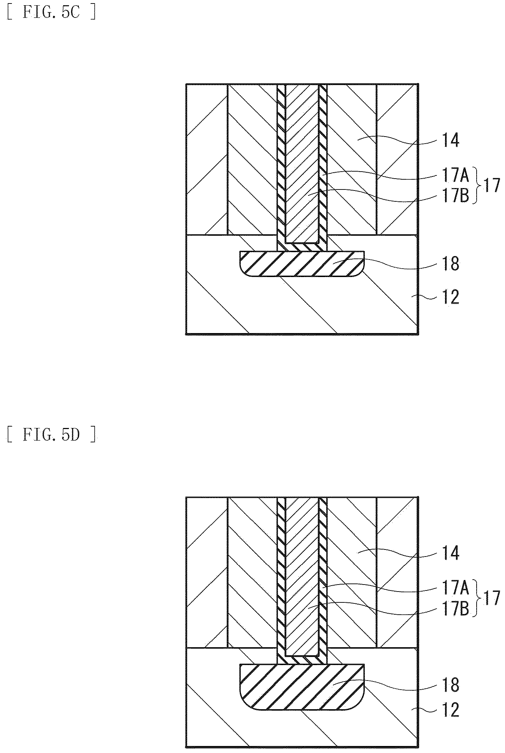

The cross-sectional shape of the oxide film 18 may be rectangular as illustrated in FIG. 1, or may be trapezoidal, for example, as illustrated in FIG. 5A. Alternatively, a rectangle having notches at corners on the side of the surface 10S1 as illustrated in FIG. 5B, or a rectangle having rounded corners on the side of the surface 10S1 as illustrated in FIGs. 5C and 5D may be adopted.

The oxide film 18 may be formed using a material having an etching rate lower than that of a silicon substrate, for example, constituting the semiconductor substrate 10. In addition, it is preferable to select, as a constituent material of the oxide film 18, a material having no fixed electric charge or a material having weaker pinning than that of the pinning film 17A formed on the inner wall or the bottom surface of the separation section 17. This makes it possible to relax pinning of holes by the pinning film 17A and thus to relax an electric field with respect to the FD 19 of an n-type, for example. Examples of such a material include silicon oxide (SiOₓ), silicon nitride (SiNₓ), and a high permittivity (High-k) material.

### [Method of Manufacturing Photodetector]

The photodetector 1 may be formed, for example, as follows.

First, as illustrated in FIG. 6A, an STI is formed on the surface 10S1 of the semiconductor substrate 10, and the element separation section 15 is formed by embedding an SiOₓ film, for example. Next, a groove 12H having a bottom in the p-well 12 is formed from the side of the surface 10S1 at a predetermined position of the semiconductor substrate 10. Subsequently, an oxide film is formed by a bottom-up film formation using an inhibitor or a sputtering method, for example, to allow the bottom of the groove 12H to be thicker than a sidewall thereof. Thereafter, the oxide film of the groove 12H is removed by wet processing using a chemical solution such as DHF to form the oxide film 18 at the bottom of the groove 12H, as illustrated in FIG. 6C.

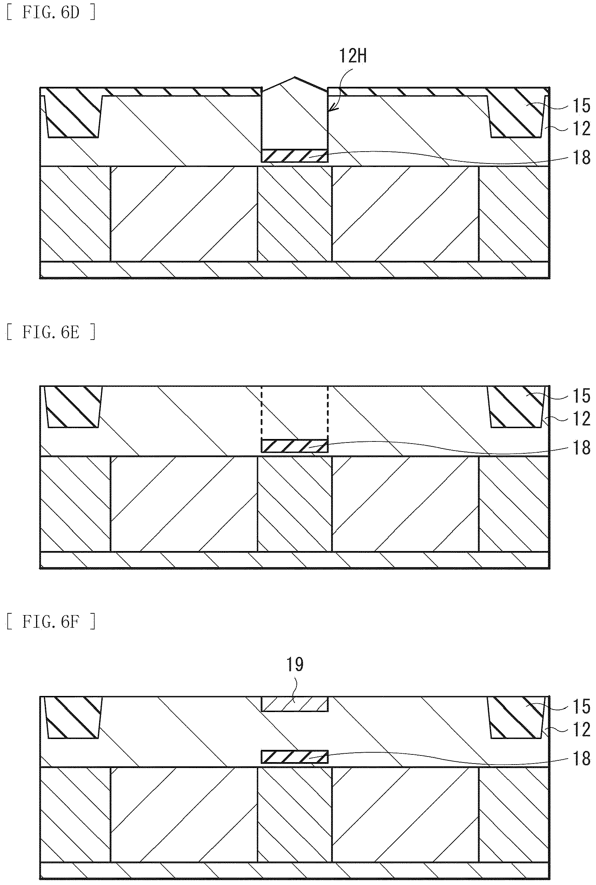

Next, as illustrated in FIG. 6D, an Si crystal is grown from the sidewall of the groove 12H by an epitaxial crystalline growth method to fill the groove 12H. Thereafter, as illustrated in FIG. 6E, the surface 10S1 of the semiconductor substrate 10 and the SiOₓ film formed on the surface 10S1 of the semiconductor substrate 10 are ground, for example, by CMP (Chemical Mechanical Polishing) to planarize the surface. Subsequently, as illustrated in FIG. 6F, n-type impurities are implanted, for example, by ion implantation to form the FD 19 above the oxide film 18. Next, an FEOL step is used to form the multilayer wiring layer 30 including the pixel transistors on the surface 10S1 of the semiconductor substrate 10.

Next, photolithography and etching are used to form the grooves 10H constituting the separation sections 16 and 17 from the side of the surface 10S2 of the semiconductor substrate 10, as illustrated in FIG. 6G. At that time, etching of the groove 10H constituting the separation section 17 is stopped at the oxide film 18 formed in the p-well 12.

Subsequently, for example, an ALD (Atomic Layer Deposition) method is used to form a pinning film on an inner wall and a bottom surface of the groove 10H. Next, for example, the ALD method is used to embed an insulating film in the groove 10H. Then, for example, the insulating film and the pinning film formed on the surface 10S2 of the semiconductor substrate 10 are ground using the CMP to planarize the surface. This allows for formation of the separation sections 16 and 17, as illustrated in FIG. 6H. Thereafter, the light-blocking film 41 is formed on the separation section 16, and then the color filter 42 and the on-chip lens 43 are formed. As described above, the photodetector 1 illustrated in FIG. 1 is completed.

### [Workings and Effects]

In the photodetector 1 according to the present embodiment, the plurality of unit pixels P is arranged in matrix. In the semiconductor substrate 10 provided with the FD 19 between the plurality of unit pixels P adjacent to each other on the surface 10S1, the separation section 16 that penetrates from the surface 10S1 of the semiconductor substrate 10 to the surface 10S is provided around the outer periphery of the unit cell U including the plurality of unit pixels P sharing the FD 19. The separation section 17 having the bottom in the semiconductor substrate 10 and stretching from the surface 10S2 of the semiconductor substrate 10 toward the surface 10S1 thereof is provided between the adjacent unit pixels P constituting the unit cell U, including an area above the FD 19. The oxide film 18 having a wider width than the width of the separation section 17 is provided at the bottom of the separation section 17. This reduces dispersion of the distance between the FD 19 and the bottom of the separation section 17. This is described below.

In recent years, a structure has been conceived in which a pixel transistor is fabricated on a side of a front surface of a semiconductor substrate, in order to achieve a fine pixel. To accomplish the structure, it is required to separately fabricate RFTI (Reverse Full Trench Isolation) and RDTI (Reverse Deep Trench Isolation).

A photodetector of a typical structure requires dry etching machining to be stopped halfway from a back surface of a semiconductor substrate upon formation of the RDTI; a variation in depth of the groove is an issue.

In contrast, in the present embodiment, the oxide film 18 is formed in advance at the bottom of the separation section 17 having the DTI structure formed above the FD 19, and the oxide film 18 is allowed to serve as an etching stopper film upon machining of the DTI (groove 10H).

As described above, in the photodetector 1 according to the present embodiment, the dispersion of the distance between the separation section 17 and the FD 19 is reduced, thus making it possible to improve the performance thereof.

In addition, in the present embodiment, the oxide film 18 serves as the etching stopper film upon the machining of the DTI (groove 10H), thus making it possible to collectively form the FTI constituting the separation section 16 and the DTI constituting the separation section 17.

Furthers, in a photodetector of a typical structure, it is envisaged as an issue that a bottom of the RDTI may result in being pinned to a p-type due to film formation of a p-type layer from a side of a back surface of a semiconductor substrate, thus reinforcing an electric field with respect to an FD of the n-type and deteriorating dark time characteristics.

In contrast, in the photodetector 1 according to the present embodiment, the formation of the oxide film 18 at the bottom of the separation section 17 allows for relaxation of the pinning of holes by the pinning film 17H above the FD 19. This relaxes an electric field with respect to the FD 19 of the n-type, thus reducing a dark current of the FD 19. That is, it becomes possible to further improve the performance of the photodetector 1.

Next, description is given of second to sixth embodiments of the present disclosure and Modification Examples 1 to 8. Hereinafter, components similar to those of the foregoing first embodiment are denoted by the same reference numerals, and descriptions thereof are omitted as appropriate.

### <2. Modification Example 1>

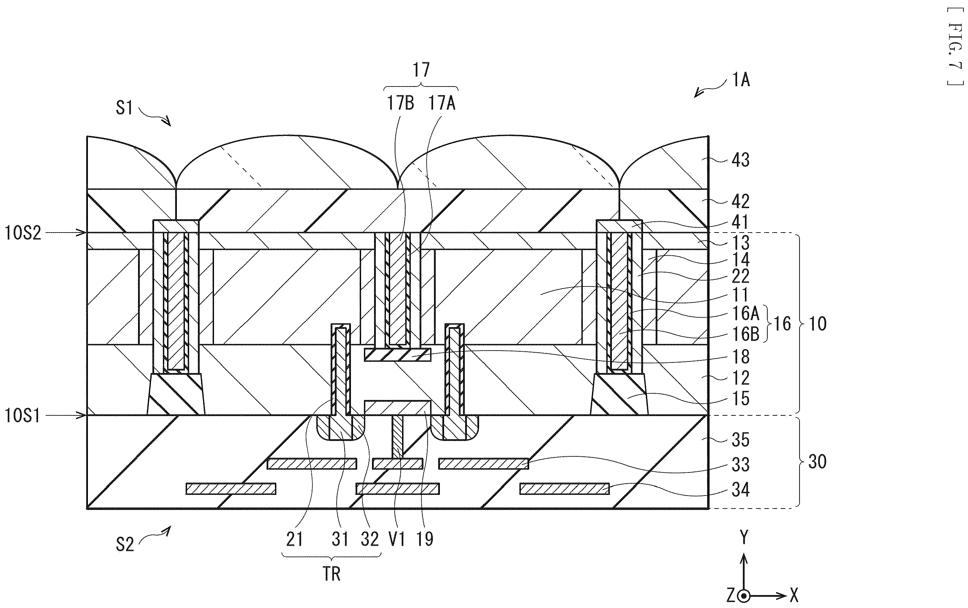

FIG. 7 schematically illustrates an example of a cross-sectional configuration of a photodetector (a photodetector 1A) according to Modification Example 1 of the present disclosure. The photodetector 1A is, for example, a CMOS image sensor, or the like used in an electronic apparatus such as a digital still camera or a video camera, and is a back side illumination photodetector, for example, in the same manner as the foregoing first embodiment.

As illustrated in FIG. 7, a p-type diffusion region 22 may be further provided on the outer walls of the separation sections 16 and 17. The p-type diffusion region 22 may be formed, for example, by plasma doping or solid phase diffusion after the formation of the grooves 10H constituting the separation sections 16 and 17.

As described above, providing the p-type diffusion region 22 on the outer walls of the separation sections 16 and 17 allows for formation of an intense electric field region in a p-n junction region between the n-type diffusion region 14 and the p-type diffusion region 22, thus enabling electric charge generated in the PD 11 to be held. This makes it possible to achieve both enlargement of saturated electric charge capacity and reduction in the dark current.

### <3.Second Embodiment>

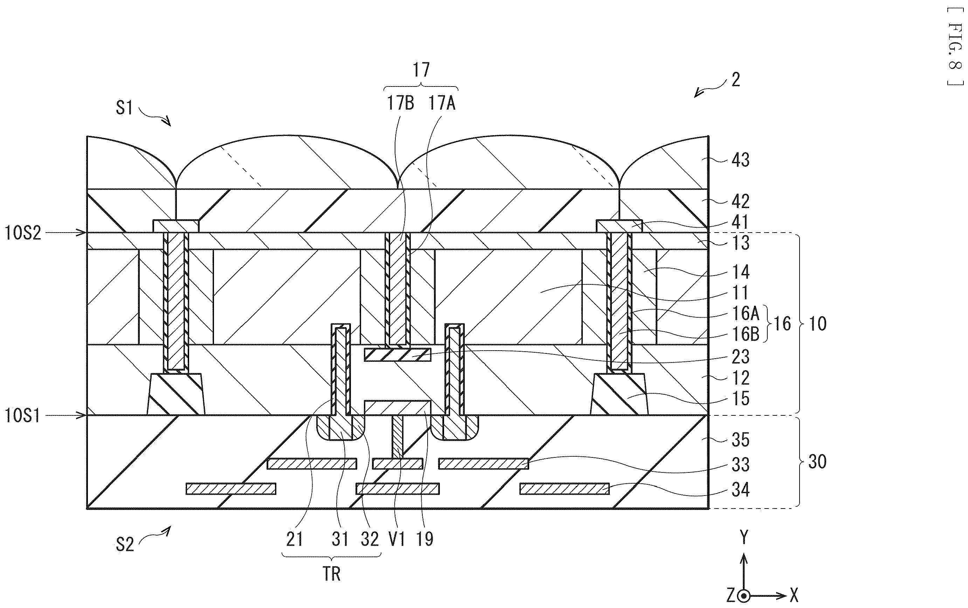

FIG. 8 schematically illustrates an example of a cross-sectional configuration of a photodetector (a photodetector 2) according to a second embodiment of the present disclosure. The photodetector 2 is, for example, a CMOS image sensor, or the like used in an electronic apparatus such as a digital still camera or a video camera, and is a back side illumination photodetector, for example, in the same manner as the foregoing first embodiment.

In the photodetector 2 according to the present embodiment, the plurality of unit pixels P is arranged in matrix. Further, in the semiconductor substrate 10 in which the FD 19 is provided on the surface (the surface 10S1) between the plurality of unit pixels P adjacent to each other, the separation section 16 is provided around an outer periphery of the plurality of unit pixels P sharing the FD 19. The separation section 16 penetrates the pair of surfaces (the surface 10S1 and the surface 10S2) opposed to each other of the semiconductor substrate 10. The separation section 17 is provided above the FD 19. The separation section 17 stretches from the surface 10S2 of the semiconductor substrate 10 toward the surface 10S1 thereof, and has a bottom in the semiconductor substrate 10. An etching inhibition layer 23 is further provided at the bottom of the separation section 17.

The etching inhibition layer 23 corresponds to a specific example of the "oxide film" of the present disclosure, and is provided in contact with the bottom of the separation section 17 formed at the interface or the inside of the p-well 12. The etching inhibition layer 23 serves as an etching stopper film upon machining of a groove (DTI) constituting the separation section 17, and reduces dispersion of a distance between the separation section 17 and the FD 19. The etching inhibition layer 23 is provided to have a wider width than the width of the separation section 17 in the X-Z plane direction, for example, as illustrated in FIG. 8.

The etching inhibition layer 23 may be formed, for example, by heat treatment and ion implantation of carbon (C), oxygen (O), nitrogen (N), or the like from the side of the surface 10S1 of the semiconductor substrate 10. That is, the etching inhibition layer 23 includes, for example, silicon carbide (SiC), silicon oxide (SiOₓ), or silicon nitride (SiNₓ).

In this manner, in the present embodiment, the formation of the etching inhibition layer 23 in advance at the bottom of the separation section 17 having the DTI structure formed above the FD 19 enables collective formation of grooves with different depths at one trench machining i.e., collective formation of the FTI constituting the separation section 16 and the DTI constituting the separation section 17.

As described above, in the photodetector 2 according to the present embodiment, a fluctuation in the characteristics due to misalignment between the separation section 16 and the separation section 17 is reduced. In addition, it becomes possible to reduce the dispersion of the distance between the separation section 17 and the FD 19 to an extent of the dispersion of the ion implantation. This makes it possible to improve the performance thereof as a photodetector.

### <4. Modification Example 2>

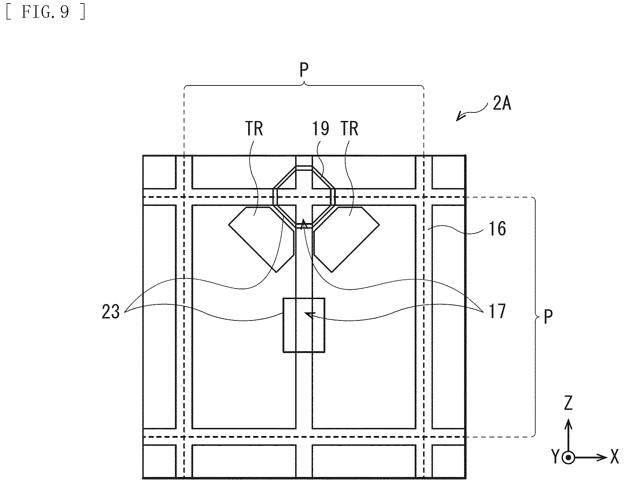

FIG. 9 schematically illustrates an example of a planar configuration of a photodetector (a photodetector 2A) according to Modification Example 2 of the present disclosure. The photodetector 2A is, for example, a CMOS image sensor, or the like used in an electronic apparatus such as a digital still camera or a video camera, and is, for example, a back side illumination photodetector that enables simultaneous acquisition of imaging information and parallax information.

The etching inhibition layer 23 described in the foregoing second embodiment can also be formed in an area other than the area above the FD 19. For example, as illustrated in FIG. 9, the separation section 17 having the DTI structure may be provided as a blooming path between two PDs 11 provided in one unit pixel P, and the etching inhibition layer 23 may be provided at the bottom of the separation section 17.

### <5. Modification Example 3>

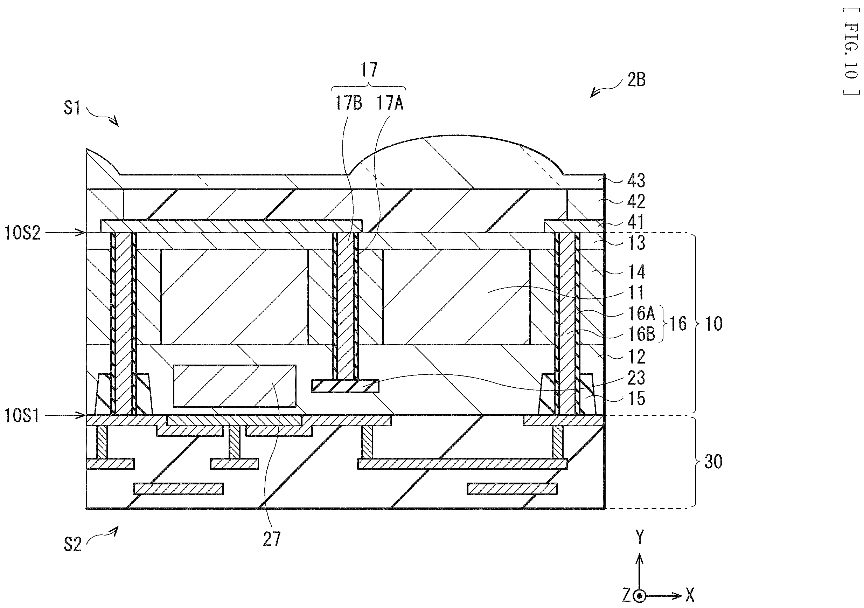

FIG. 10 schematically illustrates an example of a cross-sectional configuration of a photodetector (a photodetector 2B) according to Modification Example 3 of the present disclosure. The photodetector 2B is, for example, a CMOS image sensor, or the like used in an electronic apparatus such as a digital still camera or a video camera, and is, for example, a back side illumination photodetector of a so-called global shutter system.

The global shutter system is a system in which global exposure is performed, which basically starts exposure simultaneously for all pixels and finishes the exposure simultaneously for all the pixels. As used herein, all the pixels refer to all of pixels of a portion appearing in an image, and exclude a dummy pixel, or the like. In addition, the global shutter system also includes a system in which a region where global exposure is performed is moved while performing global exposure in a unit of multiple rows (e.g., several tens of rows) instead of all pixels simultaneously when a time difference or an image distortion is small enough to be unproblematic. In addition, the global shutter system also includes a system in which global exposure is performed on pixels of a predetermined region, instead of all of the pixels of the portion appearing in the image.

The photodetector 2B achieves a memory holding global shutter, and the unit pixel P includes a charge accumulation section (an MEM 27) that temporarily holds electric charge until transfer of electric charge generated in the PD 11 to the FD 19. For example, as illustrated in FIG. 10, the MEM 27 is formed to be embedded on the side of the surface 10S1 of the semiconductor substrate 10. The separation section 17 having the DTI structure is provided between the PD 11 and the MEM 27, and the light-blocking film 41 is formed to extend on the surface 10S2 of the semiconductor substrate 10 in which the MEM 27 is provided. The etching inhibition layer 23 described in the foregoing second embodiment may be provided at the bottom of the separation section 17 provided between the PD 11 and the MEM 27.

### <6. Third Embodiment>

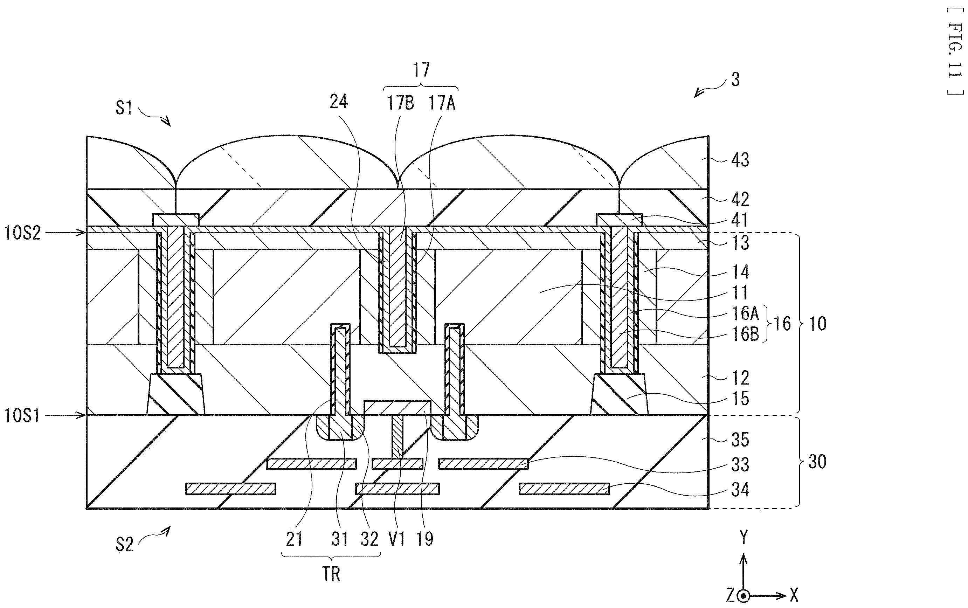

FIG. 11 schematically illustrates an example of a cross-sectional configuration of a photodetector (a photodetector 3) according to a third embodiment of the present disclosure. The photodetector 3 is, for example, a CMOS image sensor, or the like used in an electronic apparatus such as a digital still camera or a video camera, and is a back side illumination photodetector, for example, in the same manner as the foregoing first embodiment.

In the photodetector 3 according to the present embodiment, the plurality of unit pixels P is arranged in matrix. Further, in the semiconductor substrate 10 in which the FD 19 is provided on the surface (the surface 10S1) between the plurality of unit pixels P adjacent to each other, the separation section 16 is provided around an outer periphery of the plurality of unit pixels P sharing the FD 19. The separation section 16 penetrates the pair of surfaces (the surface 10S1 and the surface 10S2) opposed to each other of the semiconductor substrate 10. The separation section 17 is provided above the FD 19. The separation section 17 stretches from the surface 10S2 of the semiconductor substrate 10 toward the surface 10S1 thereof, and has a bottom in the semiconductor substrate 10. A pinning film 24, which has weaker pinning than that of the pinning film 17A formed on the inner wall of the separation section 17, is exposed to the bottom of the separation section 17.

The pinning film 24 corresponds to a specific embodiment of a "second pinning film" of the present disclosure. For example, as illustrated in FIG. 11, the pinning film 24 extends on the surface 10S2 of the semiconductor substrate 10, and is formed on the inner walls of the grooves 10H constituting the separation sections 16 and 17, with the pinning films 16A and 17A interposed therebetween. In addition, at the bottoms of the separation sections 16 and 17, the pinning films 16A and 17A are removed to cause the pinning film 24 to be exposed. As described above, examples of the available constituent material of the pinning film 24 include a material having weaker pinning than that of the pinning film 17A; examples of such a material include hafnium oxide (HfOₓ).

The separation sections 16 and 17 according to the present embodiment may be formed, for example, as follows.

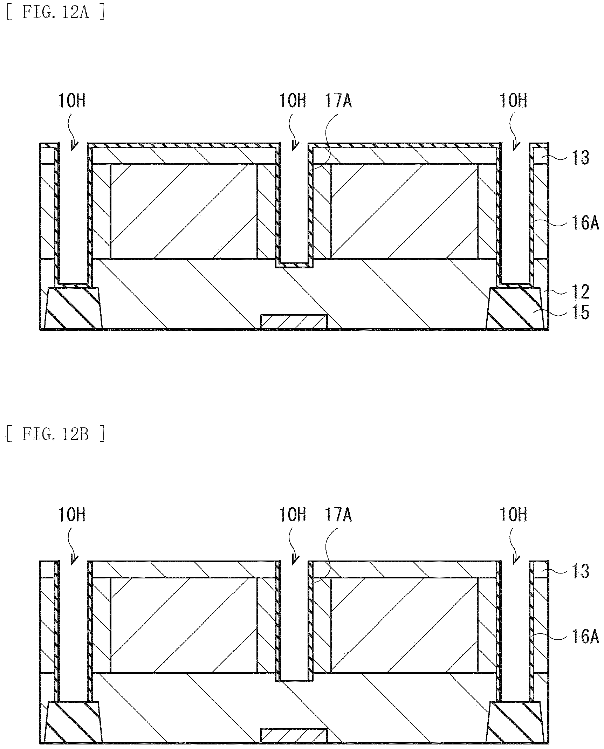

First, as in the foregoing first embodiment, the grooves 10H constituting the separation sections 16 and 17 are formed from the side of the surface 10S2 of the semiconductor substrate 10. Thereafter, for example, as illustrated in FIG. 12A, the ALD method is used to form, for example, an aluminum oxide film, which serves as the pinning films 16A and 17A, on the inner wall and the bottom surface of the groove 10H. Next, as illustrated in FIG. 12B, etch back is used to remove the aluminum oxide film formed on the surface 10S2 of the semiconductor substrate 10 and on the bottom surface of the groove 10H. This allows for formation of the pinning films 16A and 17A on respective side surfaces of the grooves 10H constituting the separation sections 16 and 17.

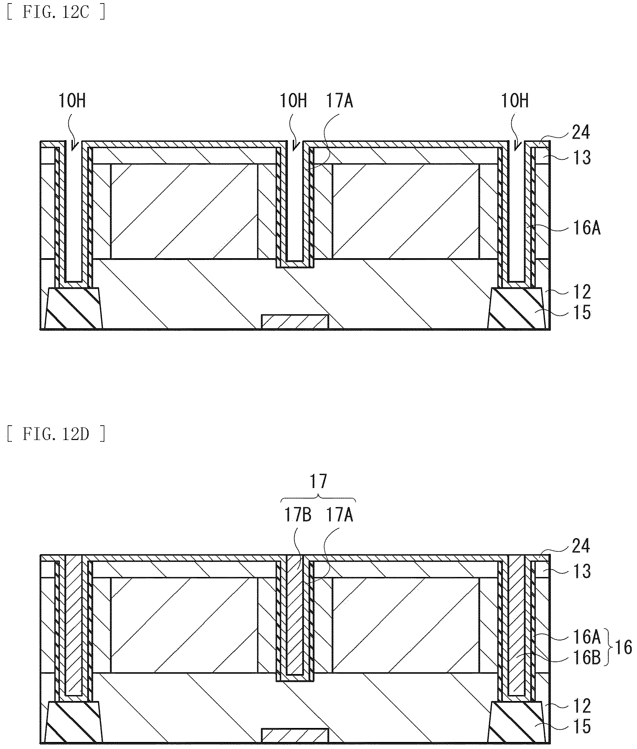

Subsequently, as illustrated in FIG. 12C, for example, the ALD method is used to form, for example, a hafnium oxide film, which serves as the pinning film 24, on the inner wall and the bottom surface of the respective grooves 10H having the side surfaces on which the pinning films 16A and 17A are formed. Next, although not illustrated, an antireflection film or the like is formed, and then, for example, the ALD method is used to embed an insulating film in the groove 10H, as illustrated in FIG. 12D. Thereafter, for example, an insulating film formed on the surface 10S2 of the semiconductor substrate 10 is ground by the CMP to planarize the surface. This allows for formation of the separation sections 16 and 17 illustrated in FIG. 11.

As described above, in the present embodiment, the pinning film 17A formed at the bottom of the separation section 17 having the DTI structure formed above the FD 19 is removed, and the pinning film 24 having weaker pinning than that of the pinning film 17A is formed on the inner wall of the separation section 17. This allows the pinning film 24 to be exposed to the bottom of the separation section 17, thus relaxing the electric field with respect to the FD 19 of the n-type while suppressing an interface state.

As described above, in the photodetector 3 according to the present embodiment, it is possible to reduce the dark current of the FD 19, thus making it possible to improve the performance thereof.

### <7. Modification Example 4>

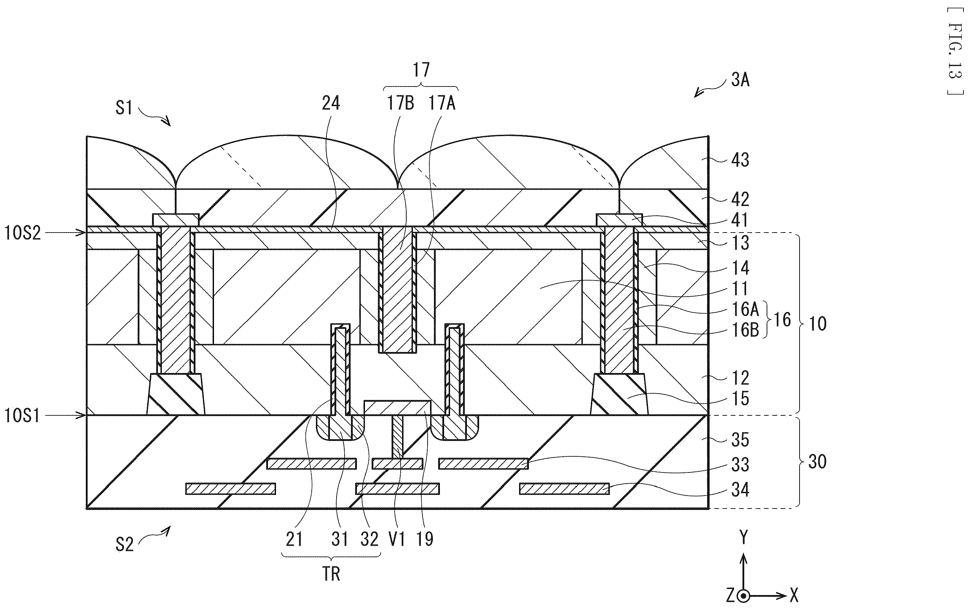

FIG. 13 schematically illustrates an example of a cross-sectional configuration of a photodetector (a photodetector 3A) according to Modification Example 4 of the present disclosure. The photodetector 3A is, for example, a CMOS image sensor, or the like used in an electronic apparatus such as a digital still camera or a video camera, and is a back side illumination photodetector, for example, in the same manner as the foregoing first embodiment.

The foregoing third embodiment exemplifies the exposure of the pinning film 24 having weaker pinning than that of the pinning film 17A to the bottom of the separation section 17; however, the bottom of the separation section 17 may be made free from pinning. Specifically, a structure may be adopted in which the insulating film 17B is exposed to the bottom of the separation section 17.

The separation sections 16 and 17 of the present modification example may be formed, for example, as follows.

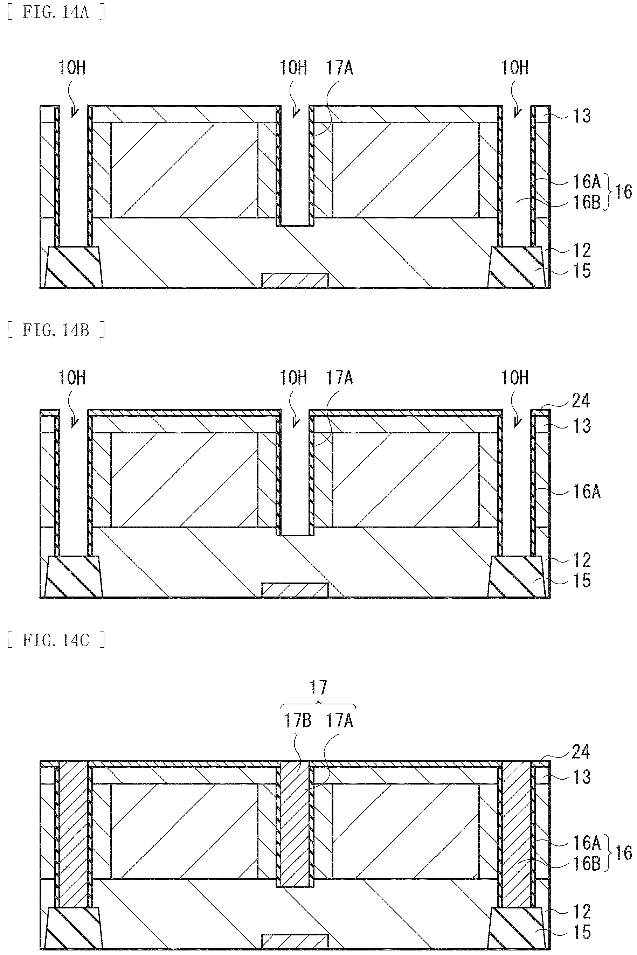

First, in the same manner as the foregoing third embodiment, for example, the ALD method is used to form an aluminum oxide film, for example, which serves as the pinning films 16A and 17A, on the inner wall and the bottom surface of the groove 10H. Thereafter, the aluminum oxide film formed on the surface 10S2 of the semiconductor substrate 10 and on the bottom surface of the groove 10H is removed by etch back to thereby form the pinning films 16A and 17A on the respective side surfaces of the grooves 10H constituting the separation sections 16 and 17, as illustrated in FIG. 14A.

Subsequently, as illustrated in FIG. 14B, for example, a sputtering method is used to form the pinning film 24 on the surface 10S2 of the semiconductor substrate 10. Next, although not illustrated, an antireflection film or the like is formed, and then, for example, the ALD method is used to embed an insulating film in the groove 10H, as illustrated in FIG. 14C. Thereafter, for example, an insulating film formed on the surface 10S2 of the semiconductor substrate 10 is ground by the CMP to planarize the surface. This allows for formation of the separation sections 16 and 17 illustrated in FIG. 13.

As described above, in the present modification example, the pinning film 17A formed at the bottom of the separation section 17 having the DTI structure formed above the FD 19 is removed, and the insulating film 17B is exposed to the bottom of the separation section 17, thereby making the bottom of the separation section 17 free from pinning. This relaxes an electric field with respect to the FD 19 of the n-type, in the same manner as the foregoing third embodiment.

As described above, in the photodetector 3A according to the present modification example, it is possible to reduce the dark current of the FD 19, in the same manner as the foregoing third embodiment, thus making it possible to improve the performance thereof.

### <8. Fourth Embodiment>

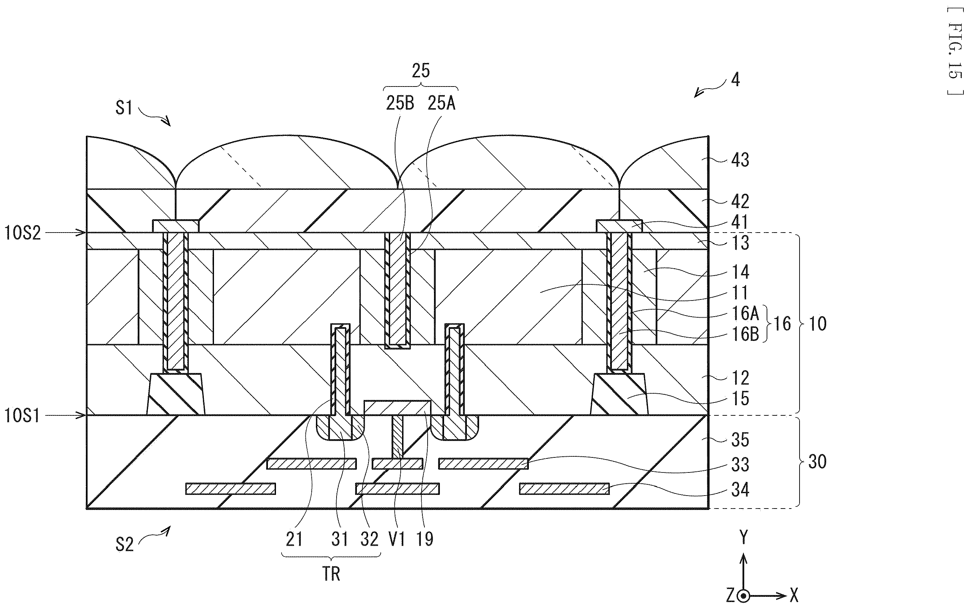

FIG. 15 schematically illustrates an example of a cross-sectional configuration of a photodetector (a photodetector 4) according to a fourth embodiment of the present disclosure. The photodetector 4 is, for example, a CMOS image sensor, or the like used in an electronic apparatus such as a digital still camera or a video camera, and is a back side illumination photodetector, for example, in the same manner as the foregoing first embodiment.

In the photodetector 4 according to the present embodiment, the plurality of unit pixels P is arranged in matrix. Further, in the semiconductor substrate 10 in which the FD 19 is provided on the surface (the surface 10S1) between the plurality of unit pixels P adjacent to each other, the separation section 16 is provided around an outer periphery of the plurality of unit pixels P sharing the FD 19. The separation section 16 penetrates the pair of surfaces (the surface 10S1 and the surface 10S2) opposed to each other of the semiconductor substrate 10. The separation section 17 is provided between the adjacent unit pixels P sharing the FD 19, except an area above the FD 19. The separation section 17 stretches from the surface 10S2 of the semiconductor substrate 10 toward the surface 10S1 thereof, and has a bottom in the semiconductor substrate 10. A separation section 25 is provided above the FD 19. The separation section 25 stretches from the surface 10S2 of the semiconductor substrate 10 toward the surface 10S1 thereof, and has a bottom in the semiconductor substrate 10. A pinning film 25A, which has weaker pinning than those of the pinning films 16A and 17A formed on the inner walls of the separation sections 16 and 17, is formed on an inner wall of the separation section 25.

The separation section 25 corresponds to a specific example of the "second groove part" of the present disclosure. The separation section 25 is configured by, for example, the pinning film 25A and an insulating film 25B. The pinning film 25A is provided on an inner wall and a bottom surface of the groove (DTI) that forms the separation section 25, and has positive fixed electric charge. The insulating film 25B fills the groove.

As described above, examples of the available constituent material of the pinning film 25A include a material having weaker pinning than those of the pinning films 16A and 17A. Examples of such a material include hafnium oxide (HfOₓ), lanthanum oxide (LaOₓ), and yttrium oxide (YOₓ). The pinning film 25A may be a monolayer film or a stacked film including different materials. This pinning film 25A corresponds to a specific example of the "second pinning film" of the present disclosure.

Examples of the constituent material of the insulating film 25B include silicon oxide (SiOₓ), silicon nitride (SiNₓ), and polysilicon (Poly-Si).

In addition, an electrically-conductive film having a light-blocking property may be embedded inside the pinning film 25A. Specific examples thereof include tungsten (W), silver (Ag), copper (Cu), aluminum (Al), and an alloy of Al and Cu. The electrically-conductive film may be a monolayer film or a stacked film including different materials. Examples of the stacked film include a stacked film of Al and cobalt (Co) or a stacked film of Al and Ti constituting a so-called barrier metal. As described above, embedding the electrically-conductive film having a light-blocking property inside the pinning film 25A makes it possible to electrically and optically separate the adjacent unit pixels P in the unit cell U from each other.

The separation sections 16, 17, and 25 according to the present embodiment may be formed, for example, as follows.

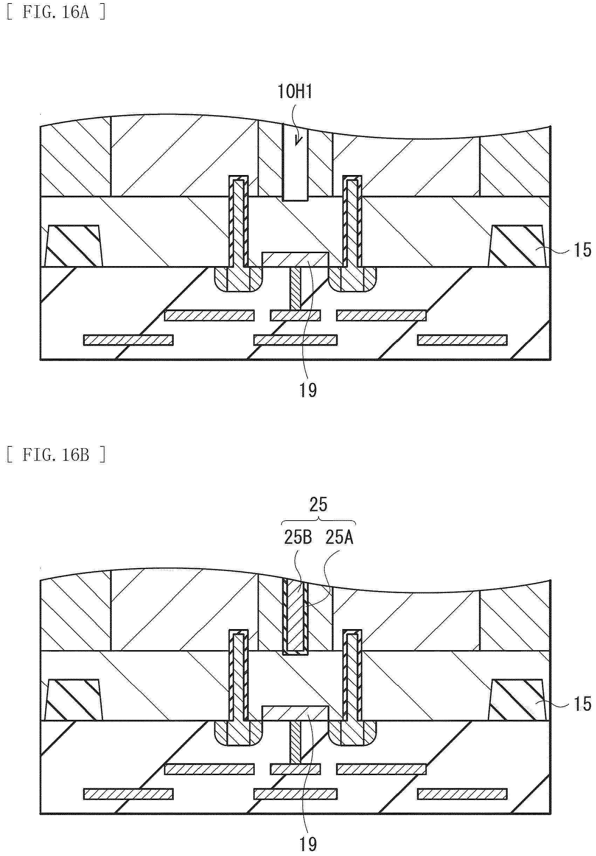

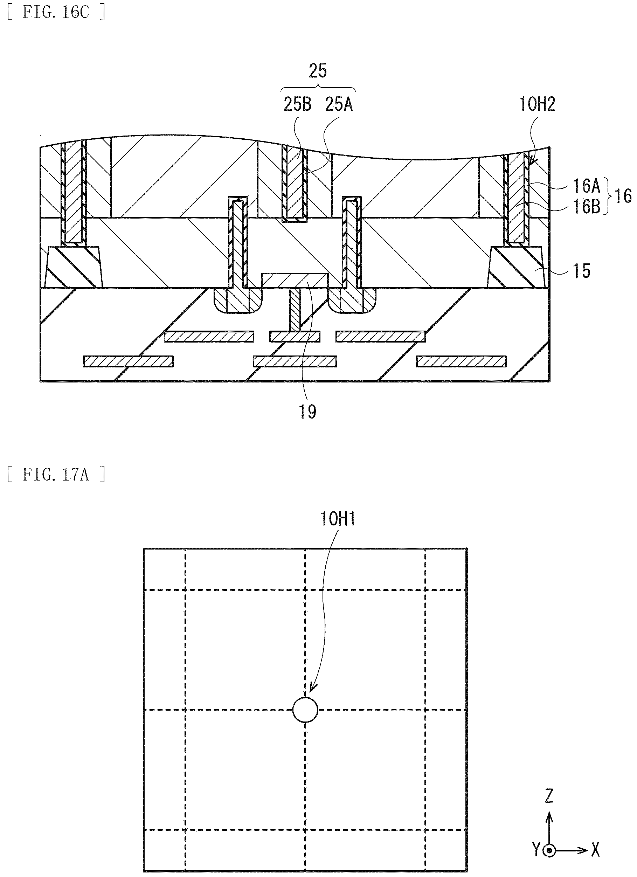

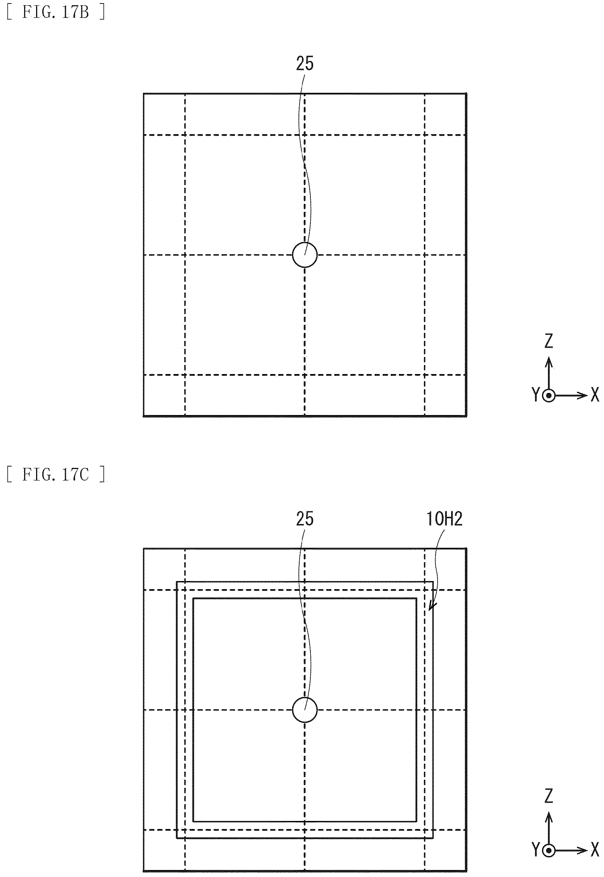

First, as in the foregoing first embodiment, the FEOL step is used to form the multilayer wiring layer 30 including the pixel transistors on the surface 10S1 of the semiconductor substrate 10, and thereafter a groove 10H1 is formed above an FD 10 as illustrated in FIGs. 16A and 17A. Next, as illustrated in FIGs. 16B and 17B, the pinning film 25A and the insulating film 25B are formed in the groove 10H1. This allows for formation of the separation section 25 above the FD 19.

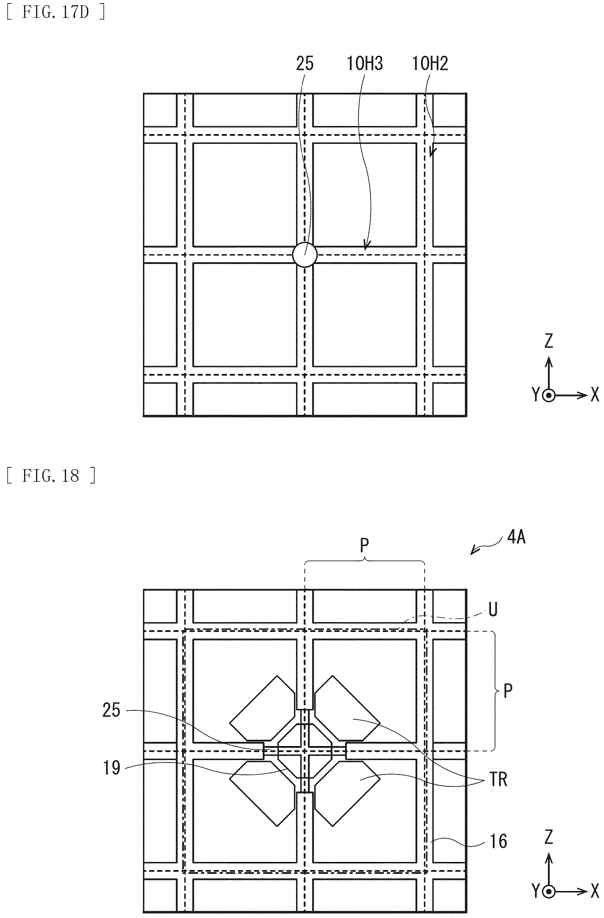

Subsequently, an FTI (a groove 10H2) is formed around the outer periphery of the unit cell U as illustrated in FIG. 17C, and then a DTI (a groove 10H3) is formed between the unit pixels P adjacent to each other in the unit cell U as illustrated in FIG. 17D. Thereafter, as illustrated in FIG. 16C, the pinning films 16A and 17A and the insulating films 16B and 17B are formed in the grooves 10H2 and 10H3. This allows for formation of the separation sections 16 and 17.

In recent years, in order to achieve a fine pixel, an imaging device has been developed in which four pixels sharing an FD arranged in two rows and two columns are separated by the RDTI and an outer periphery of the four pixels sharing the FD is separated by the RFTI. As for a concern for this structure, it is required for the RDTI and the FD to have a certain distance (500 nm to 600 nm depending on conditions) from each other, and accurate machining is necessary.

However, it has been found that machining the RDTI to have a grid pattern makes only a cross part to be machined deeply. In addition, formation of a typical pinning film on the inner wall of the RDTI may cause an electric field immediately above the FD to be strong, thus deteriorating the characteristics.

In contrast, in the present embodiment, for example, a cylindrical DTI (groove 10H1) is formed in advance above the FD 19, and the pinning film 25A, which includes a weaker pinning material than those of the pinning films 16A and 17A to be formed on the inner walls of the separation sections 16 and 17, is formed on the inner walls thereof.

As described above, in the photodetector 3 according to the present embodiment, a distance between the separation section 25 and the FD 19 is secured, and dispersion of the distance between the separation section 25 and the FD 19 is reduced. In addition, the pinning immediately above the FD 19 is reduced, thus making it possible to improve the performance thereof.

### <9. Modification Example 5>

FIG. 17 schematically illustrates an example of a planar configuration of a photodetector (a photodetector 4A) according to Modification Example 5 of the present disclosure. The photodetector 4A is, for example, a CMOS image sensor, or the like used in an electronic apparatus such as a digital still camera or a video camera, and is a back side illumination photodetector, for example, in the same manner as the foregoing first embodiment.

The foregoing fourth embodiment exemplifies the formation of the cylindrical DTI, for example, that serves as the separation section 25 above the FD 19; however, the shape of the DTI that serves as the separation section 25 is not limited thereto. For example, the planar shape of the separation section 25 may be a cross shape as illustrated in FIG. 18, or may be a polygonal shape such as a quadrangle, although no illustration is given thereof. Further, the separation section 16 having the FTI structure provided between the unit cells U adjacent to each other may be extended between the plurality of unit pixels P sharing the FD 19 to allow the separation section 16 and the separation section 25 to be in contact with each other.

Also in such a configuration, it is possible to obtain effects similar to those of the foregoing fourth embodiment.

### <10. Fifth Embodiment>

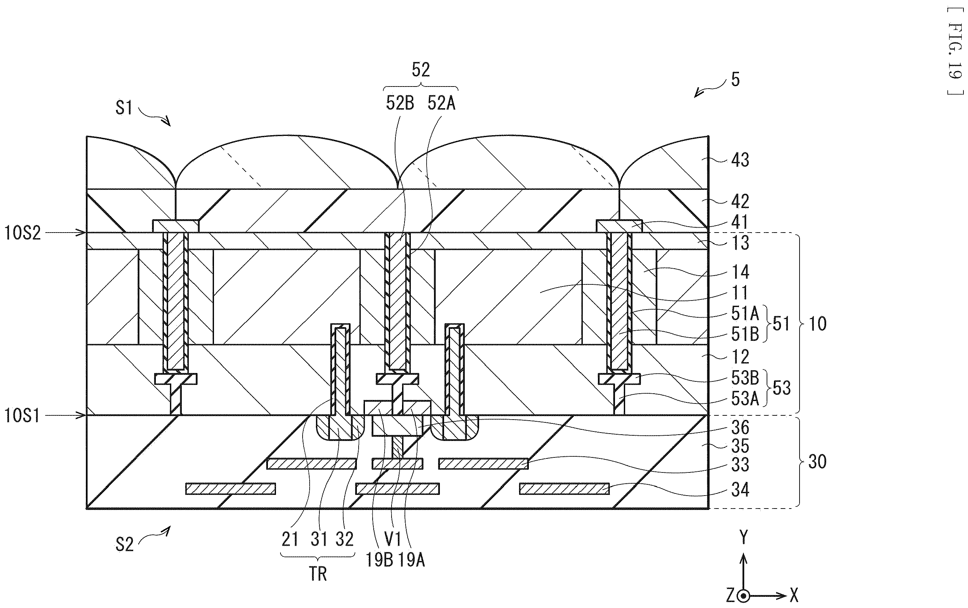

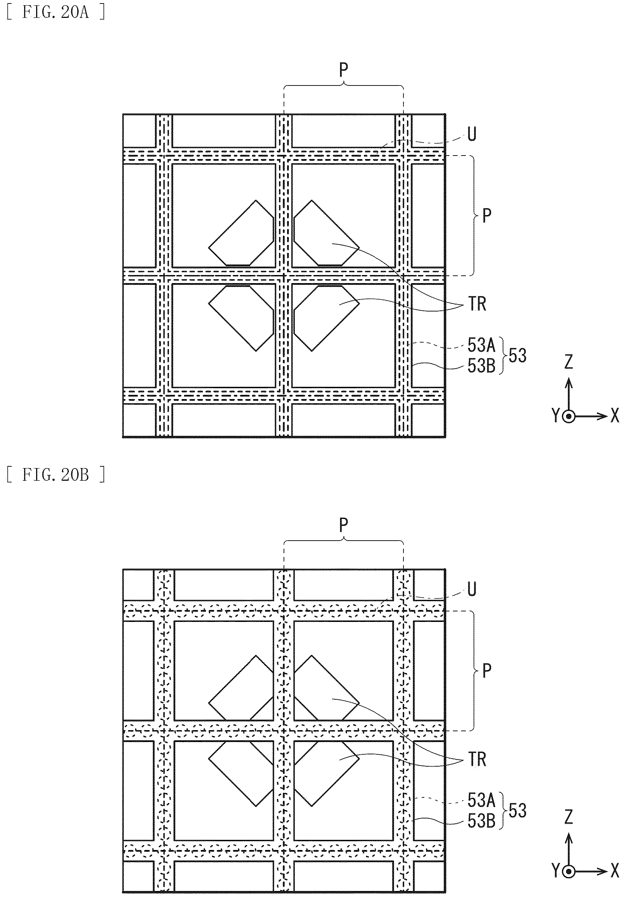

FIG. 19 schematically illustrates an example of a cross-sectional configuration of a photodetector (a photodetector 5) according to a fifth embodiment of the present disclosure. FIGs. 20A and 20B each schematically illustrate an example of a planar configuration of the photodetector 5 illustrated in FIG. 19. The photodetector 5 is, for example, a CMOS image sensor, or the like used in an electronic apparatus such as a digital still camera or a video camera, and is a back side illumination photodetector, for example, in the same manner as the foregoing first embodiment.

In the photodetector 5 according to the present embodiment, the plurality of unit pixels P is arranged in matrix. Further, in the semiconductor substrate 10 in which the FD 19 is provided on the surface (the surface 10S1) between the plurality of unit pixels P adjacent to each other, separation sections 51 and 52 each having the DTI structure, for example, are provided around an outer periphery of the plurality of unit pixels P sharing the FD 19 and between the adjacent unit pixels P sharing the FD 19. An element separation section 53 is provided at each of bottoms of the separation sections 51 and 52. The element separation section 53 has a width that is wider on a side of the bottoms of the separation sections 51 and 52 than on the side of the surface 10S1 of the semiconductor substrate 10.

The separation section 51 corresponds to a "first separation section" of the present disclosure, and is provided between the unit cells U adjacent to each other, as described above. In other words, the separation section 51 is provided to surround an outer periphery of four unit pixels arranged, for example, in two rows and two columns sharing the FD 19, and is provided in a grid pattern in the pixel section 100A. The separation section 51 electrically separates the adjacent unit cells U from each other. For example, the separation section 51 stretches from the side of the surface 10S2 of the semiconductor substrate 10 toward the side of the surface 10S1 thereof, and constitutes the DTI structure that has a bottom in the semiconductor substrate 10, specifically, at the interface or the inside of the p-well 12.

The separation section 51 is configured by, for example, a pinning film 51A and an insulating film 51B. The pinning film 51A is provided on an inner wall and a bottom surface of the groove that forms the separation section 51, and has positive fixed electric charge. The insulating film 51B fills the groove.

Examples of the constituent material of the pinning film 51A include hafnium oxide (HfOₓ), aluminum oxide (AlOₓ), zirconium oxide (ZrOₓ), tantalum oxide (TaOₓ), titanium oxide (TiOₓ), lanthanum oxide (LaOₓ), praseodymium oxide (PrOₓ), cerium oxide (CeOₓ), neodymium oxide (NdOₓ), promethium oxide (PmOₓ), samarium oxide (SmOₓ), europium oxide (EuOₓ), gadolinium oxide (GdOₓ), terbium oxide (TbOₓ), dysprosium oxide (DyOₓ), holmium oxide (HoOₓ), thulium oxide (TmOₓ), ytterbium oxide (YbOₓ), lutetium oxide (LuOₓ), yttrium oxide (YOₓ), hafnium nitride (HfNₓ), aluminum nitride (AlNₓ), hafnium oxynitride (HfOₓN_{y}), and aluminum oxynitride (AlOₓN_{y}). The pinning film 51A may be a monolayer film, or a stacked film including different materials.

Examples of the constituent material of the insulating film 51B include a silicon oxide (SiOₓ) film.

In addition, an electrically-conductive film having a light-blocking property may be embedded inside the pinning film 51A of the groove that forms the separation section 51. Specific examples thereof include tungsten (W), silver (Ag), copper (Cu), aluminum (Al), and an alloy of Al and Cu. The electrically-conductive film may be a monolayer film, or a stacked film including different materials. Examples of the stacked film include a stacked film of Al and cobalt (Co) or a stacked film of Al and Ti constituting a so-called barrier metal. As described above, embedding the electrically-conductive film having a light-blocking property inside the pinning film 51A makes it possible to electrically and optically separate the adjacent unit cells U from each other.

The separation section 52 corresponds to the "first separation section" of the present disclosure. As described above, for example, the separation section 52 is provided between the plurality of unit pixels P sharing the FD 19, and is in contact with the separation section 51 on the outer periphery of the unit cell U. Aside from the above, the separation section 52 may be selectively provided only above the FD 19 provided near an intersection of four unit pixels arranged, for example, in two rows and two columns that constitute the unit cell U. At that time, the separation section 51 extends from the outer periphery of the unit cell U toward the separation section 52 between the adjacent unit pixels P constituting the unit cell U, and is in contact with the separation section 52 in the vicinity of the FD 19 in a plan view. The separation section 52 electrically separates the adjacent unit pixels P from each other in the unit cell U, and stretches from the side of the surface 10S2 of the semiconductor substrate 10 toward the side of the surface 10S1 thereof, for example; the separation section 52 has the DTI structure having the bottom in the semiconductor substrate 10, specifically, at the interface or the inside of the p-well 12.

In the same manner as the separation section 51, the separation section 52 is configured by, for example, a pinning film 52A and an insulating film 52B. The pinning film 52A is provided on an inner wall and a bottom surface of the groove that forms the separation section 52, and has positive fixed electric charge. The insulating film 52B fills the groove.

Examples of the constituent material of the pinning film 52A include hafnium oxide (HfOₓ), aluminum oxide (AlOₓ), zirconium oxide (ZrOₓ), tantalum oxide (TaOₓ), titanium oxide (TiOₓ), lanthanum oxide (LaOₓ), praseodymium oxide (PrOₓ), cerium oxide (CeOₓ), neodymium oxide (NdOₓ), promethium oxide (PmOₓ), samarium oxide (SmOₓ), europium oxide (EuOₓ), gadolinium oxide (GdOₓ), terbium oxide (TbOₓ), dysprosium oxide (DyOₓ), holmium oxide (HoOₓ), thulium oxide (TmOₓ), ytterbium oxide (YbOₓ), lutetium oxide (LuOₓ), yttrium oxide (YOₓ), hafnium nitride (HfNₓ), aluminum nitride (AlNₓ), hafnium oxynitride (HfOₓN_{y}), and aluminum oxynitride (AlOₓN_{y}). The pinning film 52A may be a monolayer film, or a stacked film including different materials.

Examples of the constituent material of the insulating film 52B include silicon oxide (SiOₓ).

In addition, an electrically-conductive film having a light-blocking property may be embedded inside the pinning film 52A of the groove that forms the separation section 52. Specific examples thereof include tungsten (W), silver (Ag), copper (Cu), aluminum (Al), and an alloy of Al and Cu. The electrically-conductive film may be a monolayer film, or a stacked film including different materials. Examples of the stacked film include a stacked film of Al and cobalt (Co) or a stacked film of Al and Ti constituting a so-called barrier metal. As described above, embedding the electrically-conductive film having a light-blocking property inside the pinning film 52A makes it possible to electrically and optically separate the adjacent unit pixels P in the unit cell U from each other.

The element separation section 53 corresponds to a specific example of a "second separation section" of the present disclosure. The element separation section 53 separates the pixel transistors and the like from each other on the side of the surface 10S1 of the semiconductor substrate 10, and has the STI structure. As described above, the element separation section 53 is provided at the bottom of each of the separation sections 51 and 52. As described above, the element separation section 53 has a wider cross-sectional shape on the side of the bottoms of the separation sections 51 and 52 than on the side of the surface 10S1 of the semiconductor substrate 10.

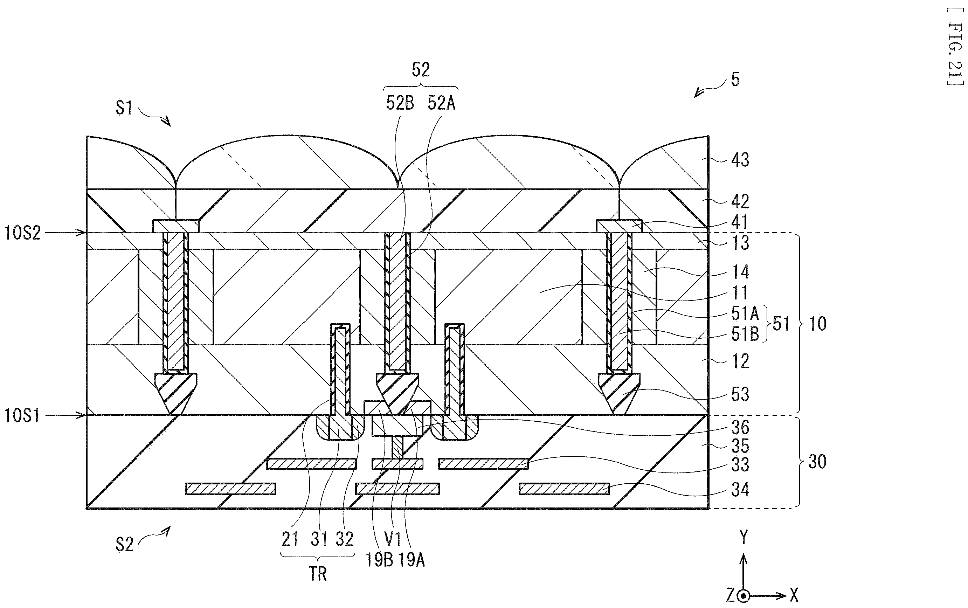

Specifically, the element separation section 53 has a T-shaped cross-sectional shape, for example, and includes a vertical part 53A and a horizontal part 53B. The horizontal part 53B has a wider width than a width of each of the separation sections 51 and 52, for example. The vertical part 53A may be provided continuously in a grid pattern at the bottoms of the separation sections 51 and 52 as illustrated in FIG. 20A, or may be provided in a grid pattern in a dot-like manner as illustrated in FIG. 20B. In addition, the cross-sectional shape of the element separation section 53 is not limited thereto, and may be a substantially trapezoidal shape, for example, as illustrated in FIG. 21.

The element separation section 53 is formed by a silicon oxide (SiOₓ) film, for example. Aside from the above, in the element separation section 53, a silicon oxide film may be formed on the inner wall thereof, and a silicon nitride film may be embedded therein. Alternatively, in the element separation section 53, a silicon oxide film may be formed on the inner wall thereof, and polysilicon may further be embedded therein.

It is to be noted that, in the present embodiment, FDs 19 are separated from each other by the element separation section 53 for every unit pixels P, and the FDs 19 are electrically coupled to each other by a contact layer 36 provided on the surface 10S1 of the semiconductor substrate 10.

The element separation section 53 may be formed, for example, as follows.

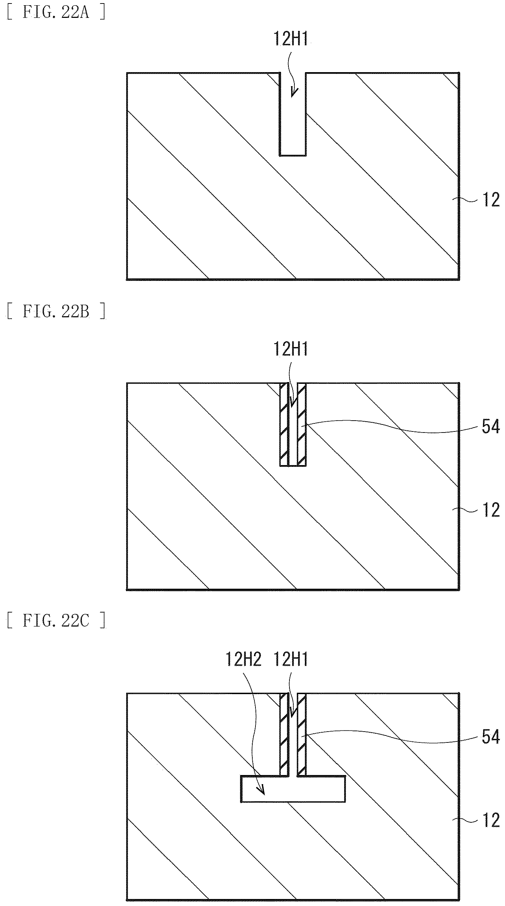

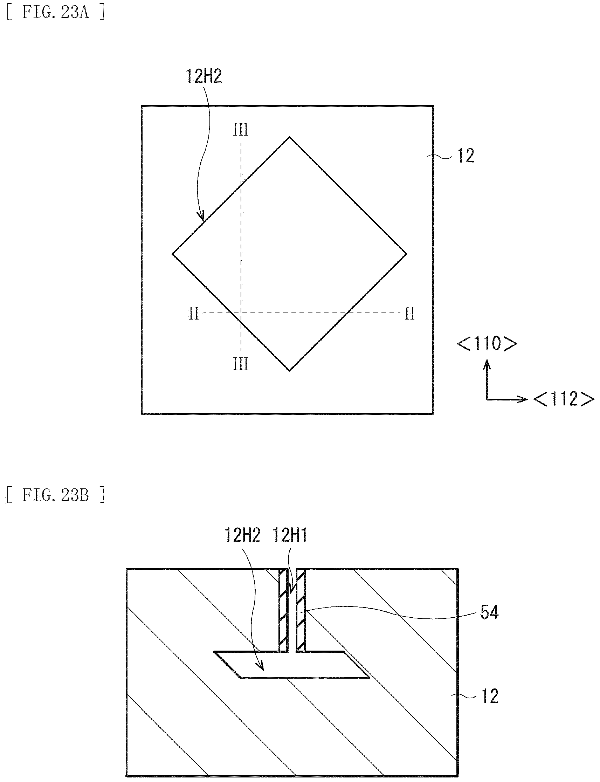

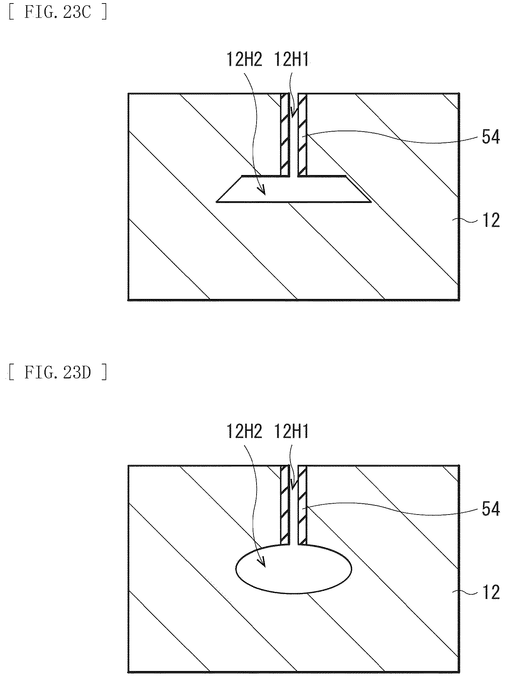

First, as illustrated in FIG. 22A, a groove 12H1 that serves as the vertical part 53A is formed in the p-well 12 from the side of the surface 10S1 of the semiconductor substrate 10. Subsequently, as illustrated in FIG. 22B, a side surface of the groove 12H1 is protected by a protective film 54. Next, as illustrated in FIG. 22C, wet etching is used to form a groove 12H2 that serves as the horizontal part 53B. At that time, in a case where an alkaline etchant is used to etch a silicon substrate having a (111) plane orientation, the planar shape of the groove 12H2 is a rectangular shape as illustrated in FIG. 23A, and the cross-sectional shape thereof is as illustrated in FIG. 23B (corresponding to a line II-II in FIG. 23A) and as illustrated in FIG. 23C (corresponding to a line III-III in FIG. 23A). In addition, as for the cross-sectional shape of the groove 12H2, a silicon substrate having a (100) plane orientation is etched as in FIG. 23D.

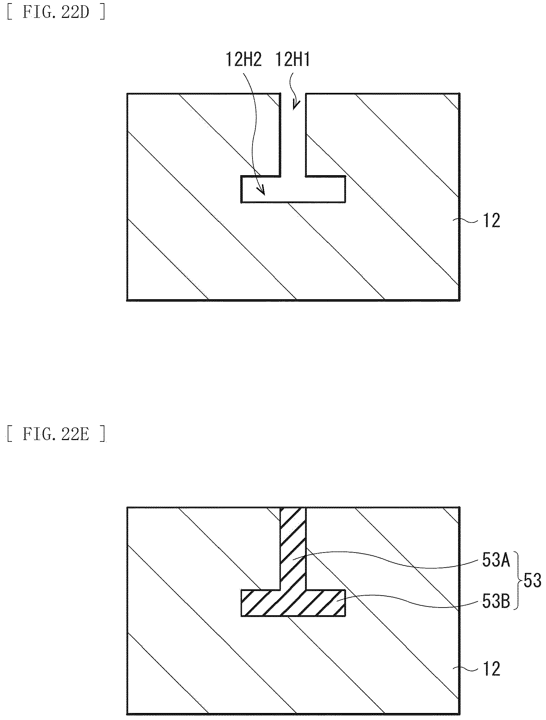

Subsequently, as illustrated in FIG. 22D, the protective film 54 is removed, and thereafter, for example, a silicon oxide film is embedded in the grooves 12H1 and 12H2, as illustrated in FIG. 22E. This allows for formation of the element separation section 53 having a T-shape.

As described above, in the present embodiment, the element separation section 53 that separates the pixel transistors or the like from each other on the side of the surface 10S1 of the semiconductor substrate 10 is allowed to have a wider shape on the side of the surface 10S2 than on the side of the surface 10S1 of the semiconductor substrate 10. This makes it possible to secure an element formation region of the surface 10S1 of the semiconductor substrate 10.

As described above, in the photodetector 5 according to the present embodiment, it is possible to improve area efficiency of an element formed on the surface 10S1 of the semiconductor substrate 10 and thus to reduce a pixel size. This makes it possible to improve the performance thereof as a photodetector.

### <11. Modification Example 6>

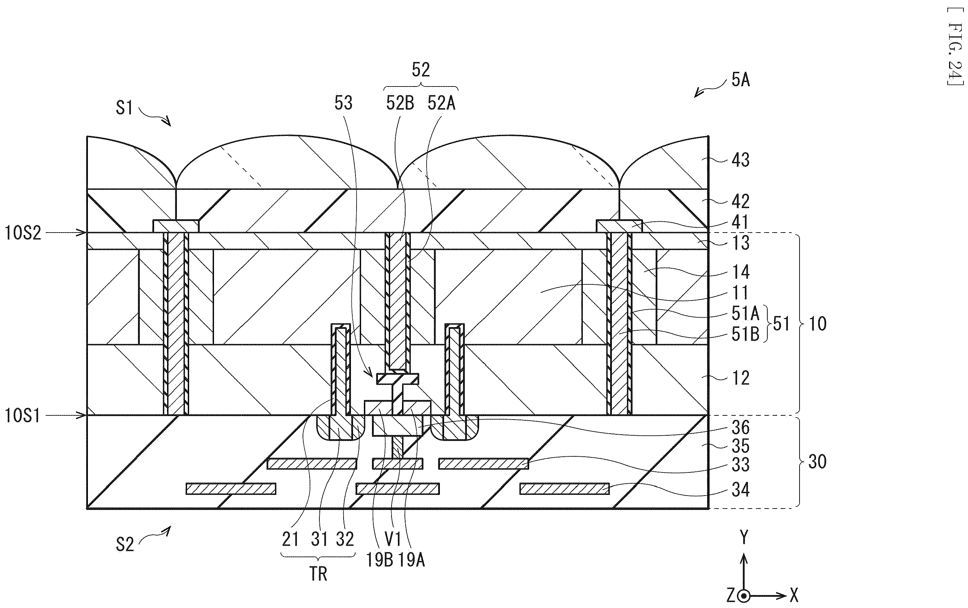

FIG. 24 schematically illustrates an example of a planar configuration of a photodetector (a photodetector 5A) according to Modification Example 6 of the present disclosure. The photodetector 5A is, for example, a CMOS image sensor, or the like used in an electronic apparatus such as a digital still camera or a video camera, and is a back side illumination photodetector, for example, in the same manner as the foregoing first embodiment.

The foregoing fifth embodiment describes the example in which the separation section 51 surrounding the outer periphery of the four unit pixels arranged, for example, in two rows and two columns sharing the FD 19 is allowed to have the DTI structure, and is allowed to have the FTI structure together with the element separation section 53. However, this is not limitative. For example, as illustrated in FIG. 24, the separation section 51 may be a structure that penetrates the semiconductor substrate 10 alone.

### <12. Modification Example 7>

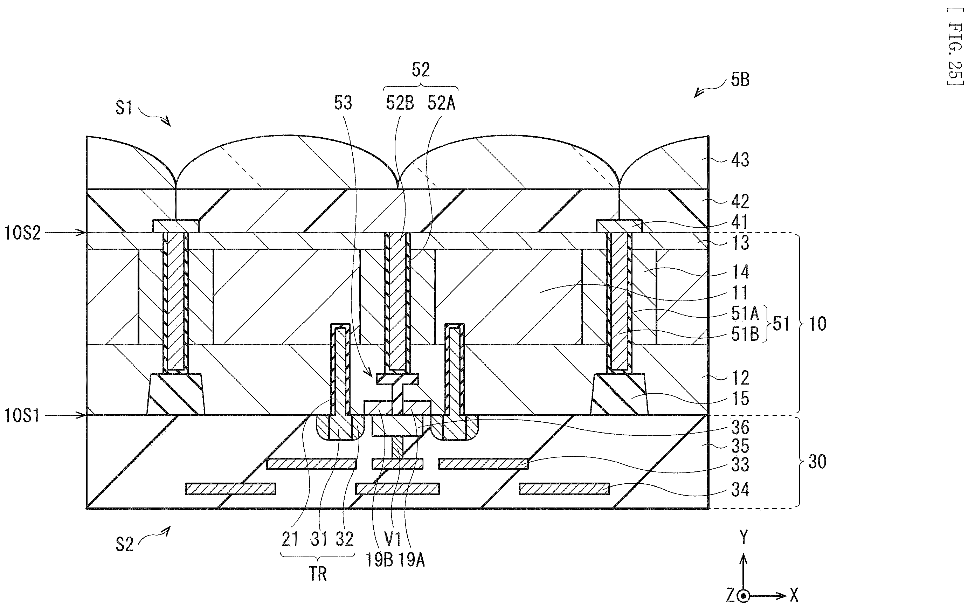

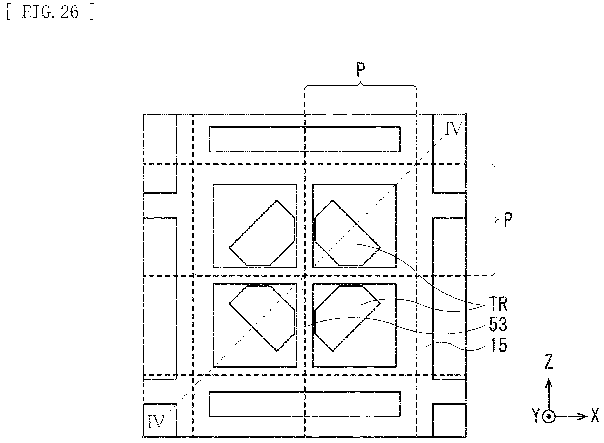

FIG. 25 schematically illustrates an example of a planar configuration of a photodetector (a photodetector 5B) according to Modification Example 7 of the present disclosure. FIG. 26 illustrates an example of a planar configuration of the photodetector 5B illustrated in FIG. 25, and FIG. 25 corresponds to a line IV-IV illustrated in FIG. 26. The photodetector 5B is, for example, a CMOS image sensor, or the like used in an electronic apparatus such as a digital still camera or a video camera, and is a back side illumination photodetector, for example, in the same manner as the foregoing first embodiment.

For example, as illustrated in FIG. 26, the pixel transistors (e.g., the reset transistor RST, the selection transistor SEL, and the amplification transistor AMP) constituting the readout circuit may be provided around the unit cell U including the plurality of unit pixels P sharing the FD 19. Alternatively, the pixel transistors may be provided in another substrate stacked on the side of the surface 10S1 and electrically coupled to the semiconductor substrate 10. As illustrated in FIG. 26, in a case where the pixel transistor is formed around the unit cell U, the element separation section 15 of the foregoing first embodiment or the like may be formed between the unit cell U and the pixel transistor.

### <13. Sixth Embodiment>

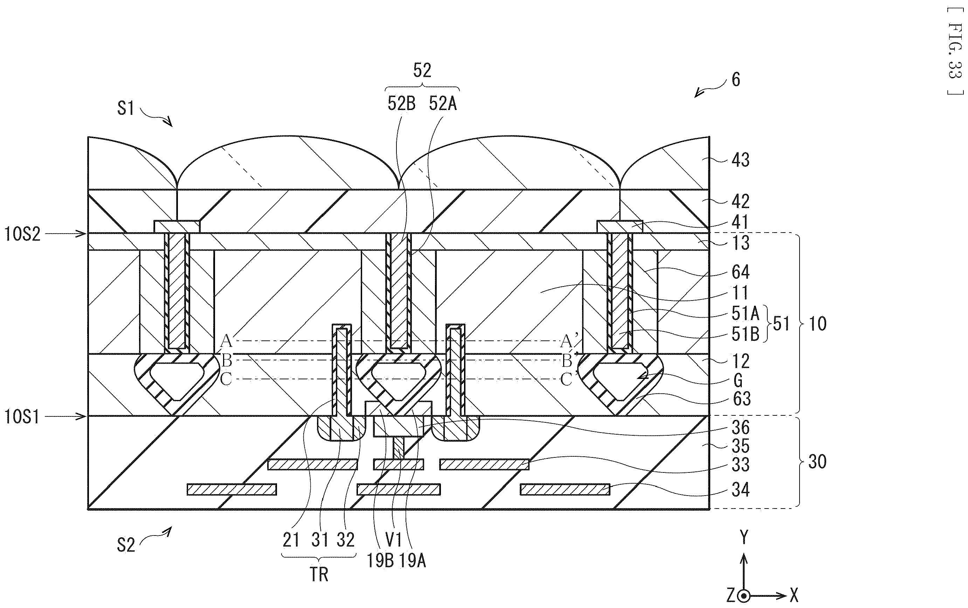

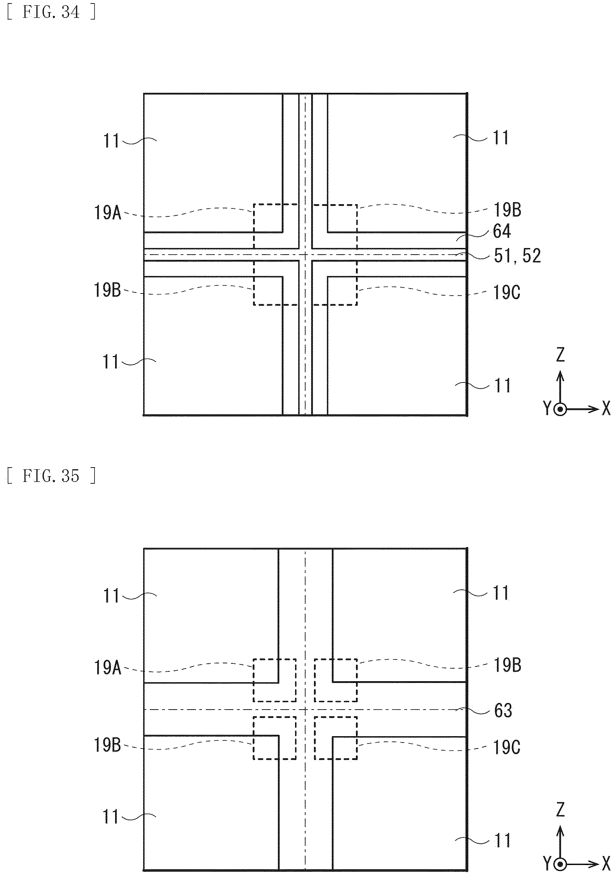

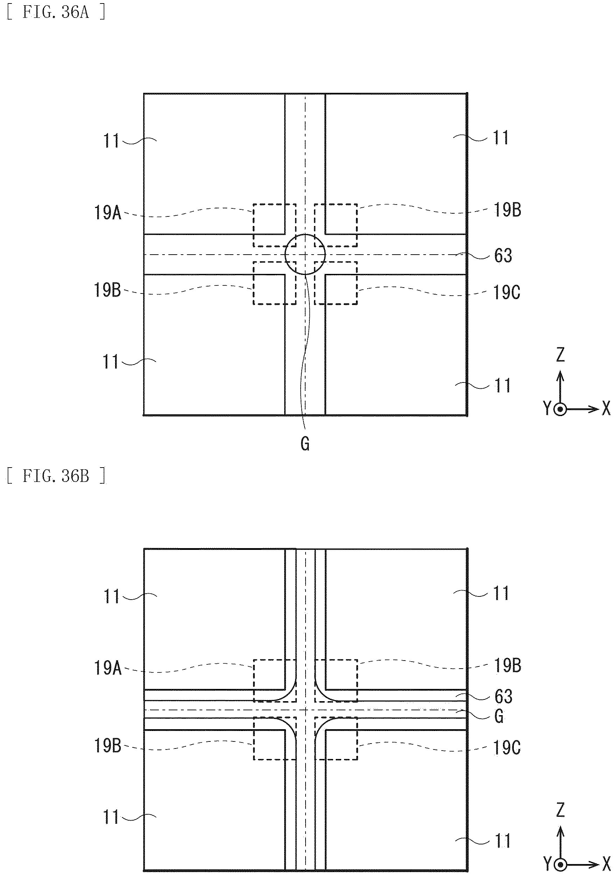

FIG. 33 schematically illustrates an example of a cross-sectional configuration of a photodetector (a photodetector 6) according to a sixth embodiment of the present disclosure. FIG. 34 is a schematic view of an example of a planar configuration of the photodetector 6 corresponding to a line A-A illustrated in FIG. 33. FIG. 35 is a schematic view of an example of a planar configuration of the photodetector 6 corresponding to a line B-B illustrated in FIG. 33. FIG. 36A is a schematic view of an example of a planar configuration of the photodetector 6 corresponding to a line C-C illustrated in FIG. 33. FIG. 36B is a schematic view of another example of the planar configuration of the photodetector 6 corresponding to the line C-C illustrated in FIG. 33. The photodetector 6 is, for example, a CMOS image sensor, or the like used in an electronic apparatus such as a digital still camera or a video camera, and is a back side illumination photodetector, for example, in the same manner as the foregoing first embodiment.

In the photodetector 6 according to the present embodiment, the plurality of unit pixels P is arranged in matrix. Further, in the semiconductor substrate 10 in which the FD 19 is provided on the surface (the surface 10S1) between the plurality of unit pixels P adjacent to each other, separation sections 51 and 52 each having the DTI structure, for example, are provided around an outer periphery of the plurality of unit pixels P sharing the FD 19 and between the adjacent unit pixels P sharing the FD 19. An element separation section 63 is provided at each of bottoms of the separation sections 51 and 52. The element separation section 63 has a width that is wider on the side of the bottoms of the separation sections 51 and 52 than on the side of the surface 10S1 of the semiconductor substrate 10. The element separation section 63 has, for example, an inclined side surface.

The separation section 51 corresponds to the "first separation section" of the present disclosure, and is provided between the unit cells U adjacent to each other, as described above. In other words, the separation section 51 is provided to surround an outer periphery of four unit pixels arranged, for example, in two rows and two columns sharing FDs 19A, 19B, 19C, and 19D, and is provided in a grid pattern in the pixel section 100A. The separation section 51 electrically separates the adjacent unit cells U from each other. For example, the separation section 51 stretches from the side of the surface 10S2 of the semiconductor substrate 10 toward the side of the surface 10S1 thereof, and constitutes the DTI structure that has the bottom in the semiconductor substrate 10, specifically, at the interface or the inside of the p-well 12.

The separation section 51 is configured by, for example, the pinning film 51A and the insulating film 51B. The pinning film 51A is provided on the inner wall and the bottom surface of the groove that forms the separation section 51, and has positive fixed electric charge. The insulating film 51B fills the groove.

Examples of the constituent material of the pinning film 51A include hafnium oxide (HfOₓ), aluminum oxide (AlOₓ), zirconium oxide (ZrOₓ), tantalum oxide (TaOₓ), titanium oxide (TiOₓ), lanthanum oxide (LaOₓ), praseodymium oxide (PrOₓ), cerium oxide (CeOₓ), neodymium oxide (NdOₓ), promethium oxide (PmOₓ), samarium oxide (SmOₓ), europium oxide (EuOₓ), gadolinium oxide (GdOₓ), terbium oxide (TbOₓ), dysprosium oxide (DyOₓ), holmium oxide (HoOₓ), thulium oxide (TmOₓ), ytterbium oxide (YbOₓ), lutetium oxide (LuOₓ), yttrium oxide (YOₓ), hafnium nitride (HfNₓ), aluminum nitride (AlNₓ), hafnium oxynitride (HfOₓN_{y}), and aluminum oxynitride (AlOₓN_{y}). The pinning film 51A may be a monolayer film, or a stacked film including different materials.

Examples of the constituent material of the insulating film 51B include a silicon oxide (SiOₓ) film.

In addition, an electrically-conductive film having a light-blocking property may be embedded inside the pinning film 51A of the groove that forms the separation section 51. Specific examples thereof include tungsten (W), silver (Ag), copper (Cu), aluminum (Al), and an alloy of Al and Cu. The electrically-conductive film may be a monolayer film, or a stacked film including different materials. Examples of the stacked film include a stacked film of Al and cobalt (Co) or a stacked film of Al and Ti constituting a so-called barrier metal. As described above, embedding the electrically-conductive film having a light-blocking property inside the pinning film 51A makes it possible to electrically and optically separate the adjacent unit cells U from each other.

The separation section 52 corresponds to the "first separation section" of the present disclosure. As described above, for example, the separation section 52 is provided between the plurality of unit pixels P sharing the FD 19, and is in contact with the separation section 51 on the outer periphery of the unit cell U. Aside from the above, the separation section 52 may be selectively provided only above the FD 19 provided near an intersection of four unit pixels arranged, for example, in two rows and two columns that constitute the unit cell U. At that time, the separation section 51 extends from the outer periphery of the unit cell U toward the separation section 52 between the adjacent unit pixels P constituting the unit cell U, and is in contact with the separation section 52 in the vicinity of the FD 19 in a plan view. The separation section 52 electrically separates the adjacent unit pixels P from each other in the unit cell U, and stretches from the side of the surface 10S2 of the semiconductor substrate 10 toward the side of the surface 10S1 thereof, for example; the separation section 52 has the DTI structure having the bottom in the semiconductor substrate 10, specifically, at the interface or the inside of the p-well 12.

In the same manner as the separation section 51, the separation section 52 is configured by, for example, the pinning film 52A and the insulating film 52B. The pinning film 52A is provided on the inner wall and the bottom surface of the groove that forms the separation section 52, and has positive fixed electric charge. The insulating film 52B fills the groove.

Examples of the constituent material of the pinning film 52A include hafnium oxide (HfOₓ), aluminum oxide (AlOₓ), zirconium oxide (ZrOₓ), tantalum oxide (TaOₓ), titanium oxide (TiOₓ), lanthanum oxide (LaOₓ), praseodymium oxide (PrOₓ), cerium oxide (CeOₓ), neodymium oxide (NdOₓ), promethium oxide (PmOₓ), samarium oxide (SmOₓ), europium oxide (EuOₓ), gadolinium oxide (GdOₓ), terbium oxide (TbOₓ), dysprosium oxide (DyOₓ), holmium oxide (HoOₓ), thulium oxide (TmOₓ), ytterbium oxide (YbOₓ), lutetium oxide (LuOₓ), yttrium oxide (YOₓ), hafnium nitride (HfNₓ), aluminum nitride (AlNₓ), hafnium oxynitride (HfOₓN_{y}), and aluminum oxynitride (AlOₓN_{y}). The pinning film 52A may be a monolayer film, or a stacked film including different materials.

Examples of the constituent material of the insulating film 52B include silicon oxide (SiOₓ).

In addition, an electrically-conductive film having a light-blocking property may be embedded inside the pinning film 52A of the groove that forms the separation section 52. Specific examples thereof include tungsten (W), silver (Ag), copper (Cu), aluminum (Al), and an alloy of Al and Cu. The electrically-conductive film may be a monolayer film, or a stacked film including different materials. Examples of the stacked film include a stacked film of Al and cobalt (Co) or a stacked film of Al and Ti constituting a so-called barrier metal. As described above, embedding the electrically-conductive film having a light-blocking property inside the pinning film 52A makes it possible to electrically and optically separate the adjacent unit pixels P in the unit cell U from each other.

The element separation section 63 corresponds to a specific example of the "second separation section" of the present disclosure. The element separation section 63 separates the pixel transistors and the like from each other on the side of the surface 10S1 of the semiconductor substrate 10, and has the STI structure. The element separation section 63 is provided at the bottom of each of the separation sections 51 and 52. As described above, the element separation section 63 is wider on the side of the bottoms of the separation sections 51 and 52 than on the side of the surface 10S1 of the semiconductor substrate 10. Further, the element separation section 63 has a cross-sectional shape of inclined side surface. Specifically, the element separation section 63 has a substantially trapezoidal shape.

A p-type diffusion region 64 is provided at each of the side surfaces of the separation sections 51 and 52. As for a width at a side of the bottom of the element separation section 63, the element separation section 63 preferably has a width equal to or more than a width of the p-type diffusion region 64, for example. This makes it possible, for example, to suppress diffusion of p-type impurities (e.g., boron (B)) doped in the p-type diffusion region 64 to a charge transfer path.

The element separation section 63 is formed by a silicon oxide (SiOₓ) film, for example. Aside from the above, in the element separation section 63, a silicon oxide film may be formed on the inner wall thereof, and a silicon nitride film may be embedded therein. Alternatively, in the element separation section 63, a silicon oxide film may be formed on the inner wall thereof, and polysilicon may further be embedded therein.

The element separation section 63 may further have an air gap G formed therein. The air gap G is formed at an intersection of the four unit pixels P adjacent to each other in an X-axis direction and in a Y-axis direction, for example, as illustrated in FIG. 36A. Alternatively, as illustrated in FIG. 36B, the air gap G may be formed to extend between the unit pixels P adjacent to each other in the X-axis direction and in the Y-axis direction.

The element separation section 63 may be formed, for example, as follows.

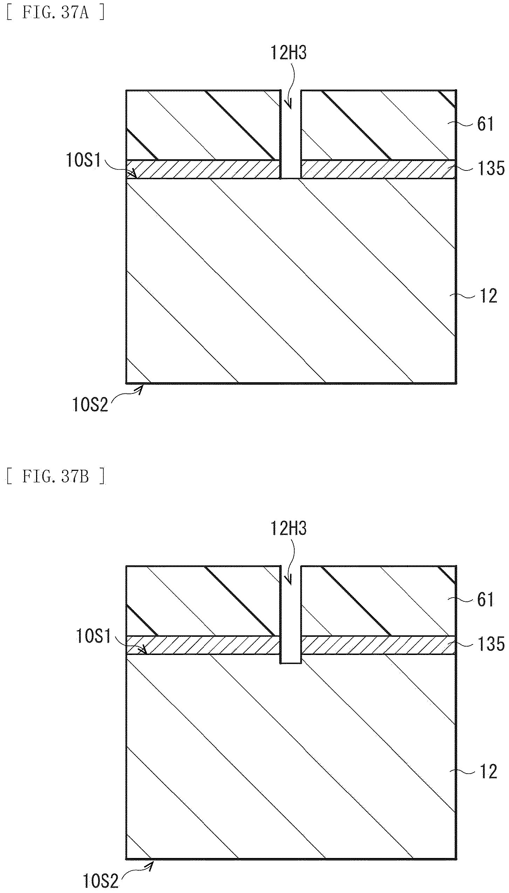

First, as illustrated in FIG. 37A, a groove 12H3 is formed in a silicon nitride film 135 and a silicon oxide film 61 from the side of the surface 10S1 of the semiconductor substrate 10 on which the silicon nitride film 135 and the silicon oxide film 61 are stacked. Subsequently, the groove 12H3 is stretched into the p-well 12 by anisotropic etching, as illustrated in FIG. 37B.

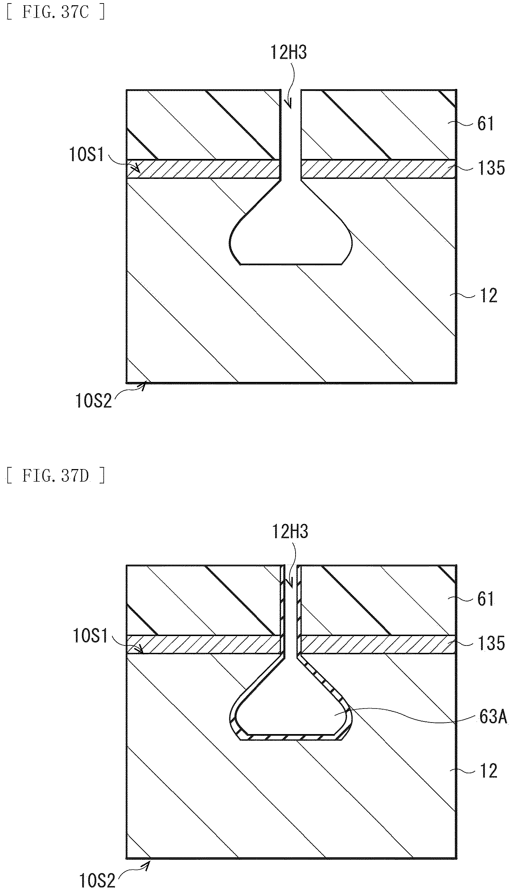

Next, isotropic etching is performed. This allows the p-well 12 to be isotropically etched to form the groove 12H3 having an inclination angle of 45°, for example, as illustrated in FIG. 37C. The inclination angle of the groove 12H3 may be controlled by preparing an etch gas to be used. **In** addition, in order to enable suppression of the diffusion of the p-type impurities doped in the p-type diffusion region 64 to the charge transfer path as described above, for example, an etching depth may be such a depth (e.g., 50 nm) as to enable an area of the groove 12H3 constituting the element separation section 63 in an X-Y plane direction to surround a length of the diffusion of the p-type impurities doped in the p-type diffusion region 64.

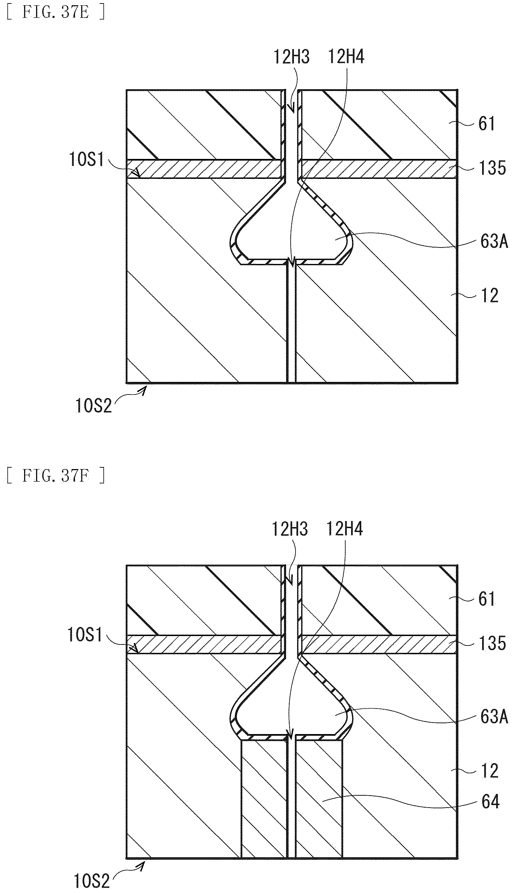

Subsequently, as illustrated in FIG. 37D, for example, a silicon oxide film 63A including SiO₂/LP-SiN/SiO₂ is formed on a sidewall of the groove 12H3. Next, as illustrated in FIG. 37E, a groove 12H4 stretching from the inside of the groove 12H3 toward the surface 10S2 is formed. Subsequently, as illustrated in FIG. 37F, for example, boron (B) is diffused in a lateral direction in the groove 12H4 using solid-phase diffusion or plasma doping, for example, to form the p-type diffusion region 64.

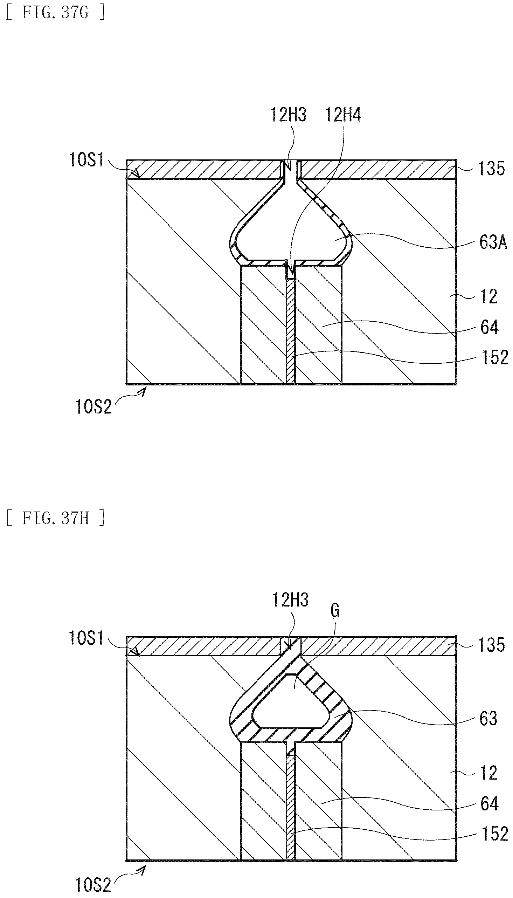

Next, as illustrated in FIG. 37G, a polysilicon film 152 is embedded in the groove 12H4, and then etch back is performed to remove the silicon oxide film 61. Thereafter, as illustrated in FIG. 37H, a silicon oxide film is embedded in the groove 12H3 using the ALD method, for example, and then etch back is performed to remove the silicon oxide film formed on the silicon nitride film 135. This allows for formation of the element separation section 63 having the air gap G therein.

The element separation section 63 may be formed, for example, as follows.

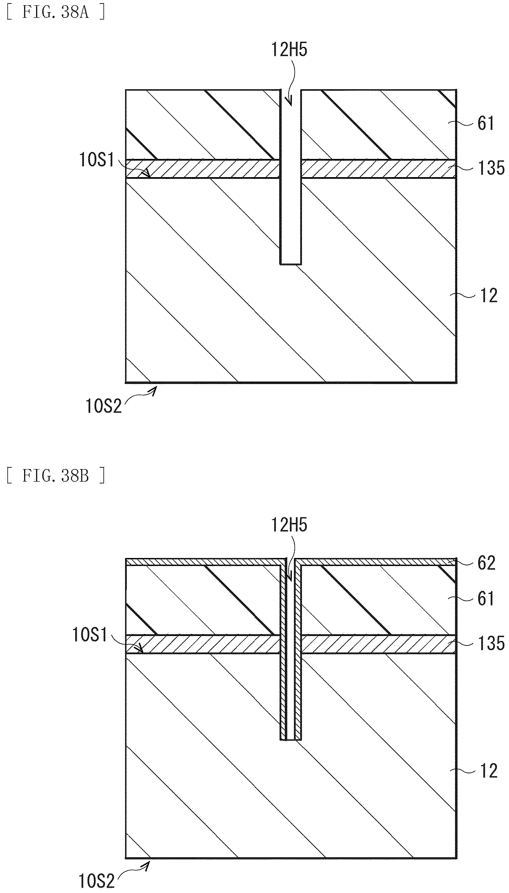

First, a method similar to that described above is used to form a groove 12H5 in the silicon nitride film 135 and the silicon oxide film 61 from the side of the surface 10S1 of the semiconductor substrate 10 on which the silicon nitride film 135 and the silicon oxide film 61 are stacked. Thereafter, the groove 12H5 is stretched into the p-well 12 by anisotropic etching, as illustrated in FIG. 38A.

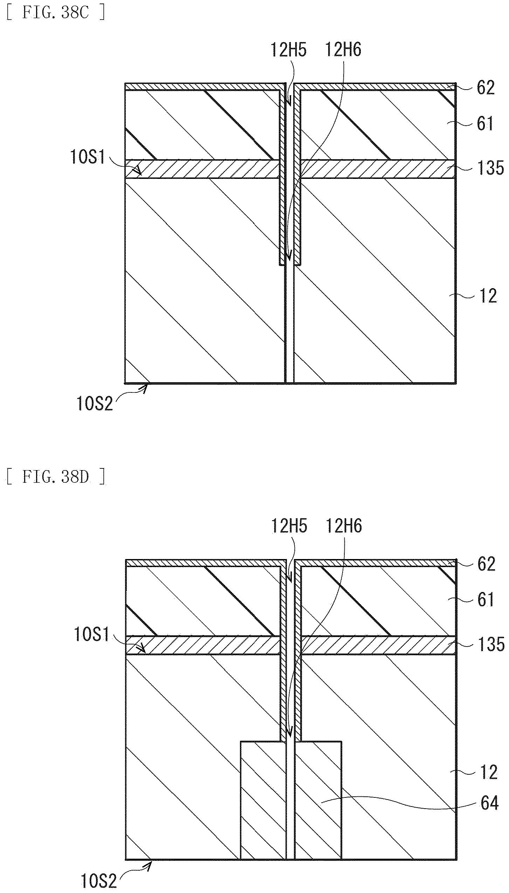

Next, as illustrated in FIG. 38B, for example, a protective film 62 including SiO₂/LP-SiN/SiO₂ is formed on a sidewall of the groove 12H5. Subsequently, as illustrated in FIG. 38C, a groove 12H6 stretching from the inside of the groove 12H5 toward the surface 10S2 is formed. Next, as illustrated in FIG. 38D, for example, boron (B) is diffused in a lateral direction in the groove 12H6 using solid-phase diffusion or plasma doping to form the p-type diffusion region 64.

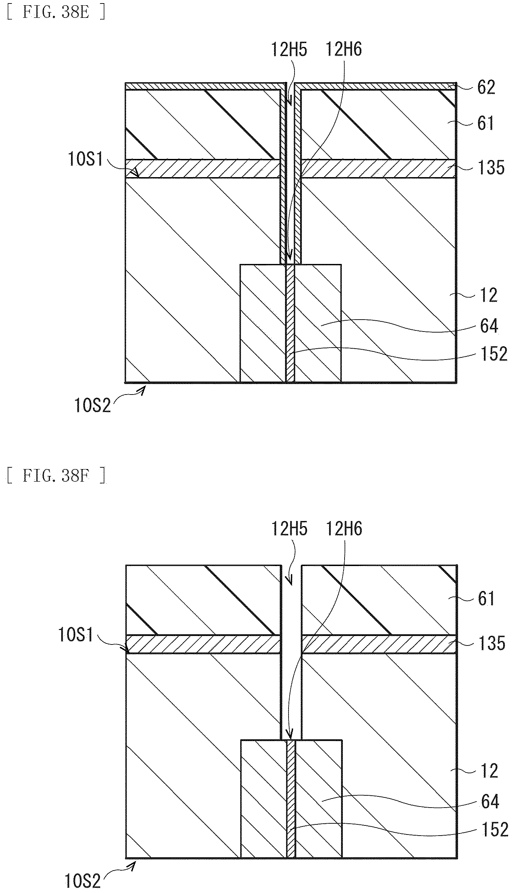

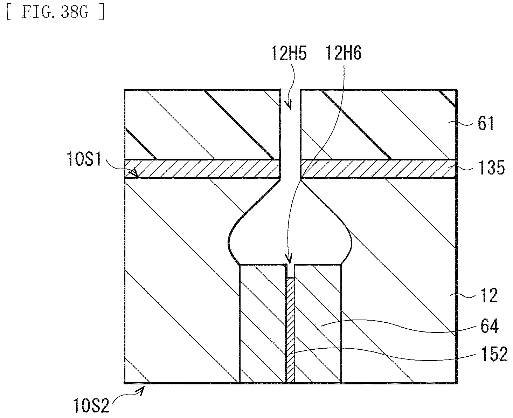

Subsequently, the polysilicon film 152 is embedded in the groove 12H6 as illustrated in FIG. 38E, and then etch back is performed to remove the protective film 62 as illustrated in FIG. 38F. Thereafter, as illustrated in FIG. 38G, isotropic etching is performed to thereby form the groove 12H5 having an inclination angle of 45°, for example. Thereafter, a silicon oxide film is embedded in the groove 12H3 using the ALD method, for example, and then etch back is performed to remove the silicon oxide film formed on the silicon nitride film 135. This allows for formation of the element separation section 63 having the air gap G therein.

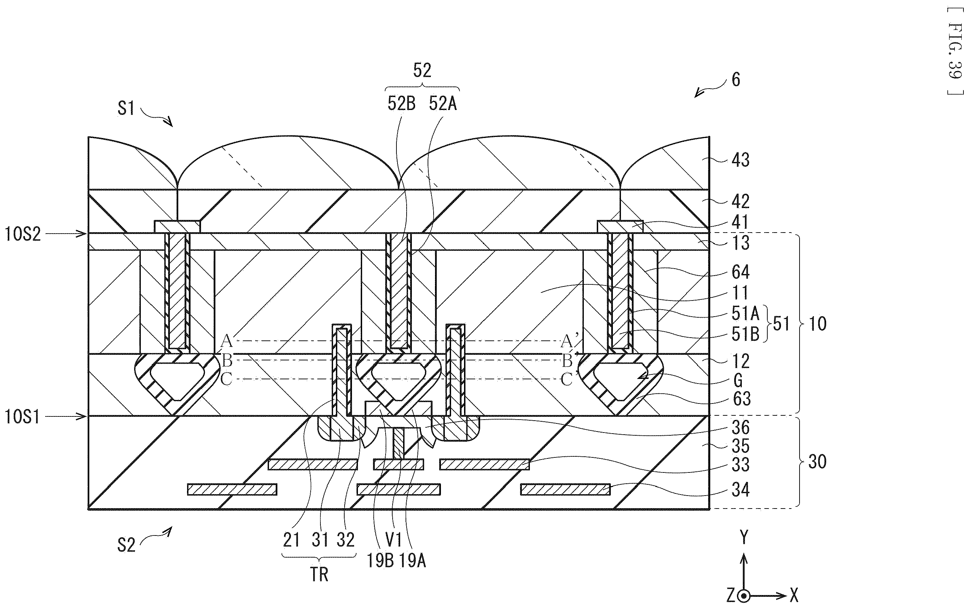

It is to be noted that, as illustrated in FIG. 33, the present embodiment describes the example in which the contact layer 36 that electrically couples together the FDs 19 (e.g., the FDs 19A, 19B, 19C, and 19D) provided for every unit pixels P is provided between the transfer transistors TR adjacent to each other. However, this is not limitative. For example, as illustrated in FIG. 39, a portion of the contact layer 36 may ride on the sidewall 32 of the transfer transistor.

As described above, in the present embodiment, the element separation section 63 that separates the pixel transistors or the like from each other on the side of the surface 10S1 of the semiconductor substrate 10 is allowed to have a wider shape on the side of the surface 10S2 than on the side of the surface 10S1 of the semiconductor substrate 10. This makes it possible to secure an element formation region of the surface 10S1 of the semiconductor substrate 10, in the same manner as the foregoing fifth embodiment.

As described above, in the photodetector 6 according to the present embodiment, it is possible to improve area efficiency of an element formed on the surface 10S1 of the semiconductor substrate 10 and thus to reduce a pixel size. This makes it possible to improve the performance thereof as a photodetector.

In addition, in the photodetector 6 according to the present embodiment, the width of the element separation section 63 on the side of bottom is set to, for example, a width equal to or more than the width of the p-type diffusion region 64, thus making it possible to suppress the diffusion of p-type impurities doped in the p-type diffusion region 64 to the charge transfer path. This makes it possible to reduce deterioration in transfer characteristics due to dispersion of the shapes of the separation sections 51 and 52.

### <14. Modification Example 8>

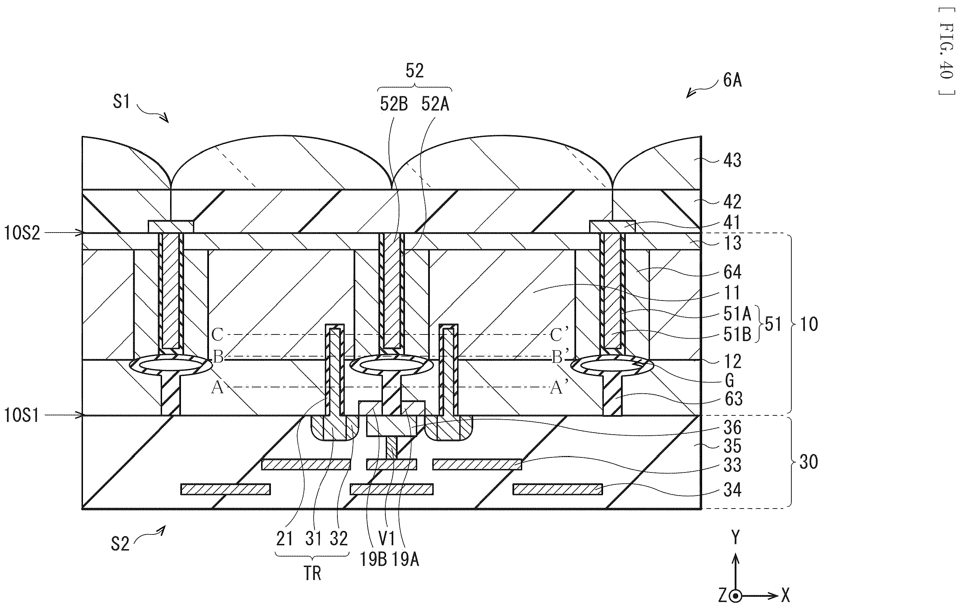

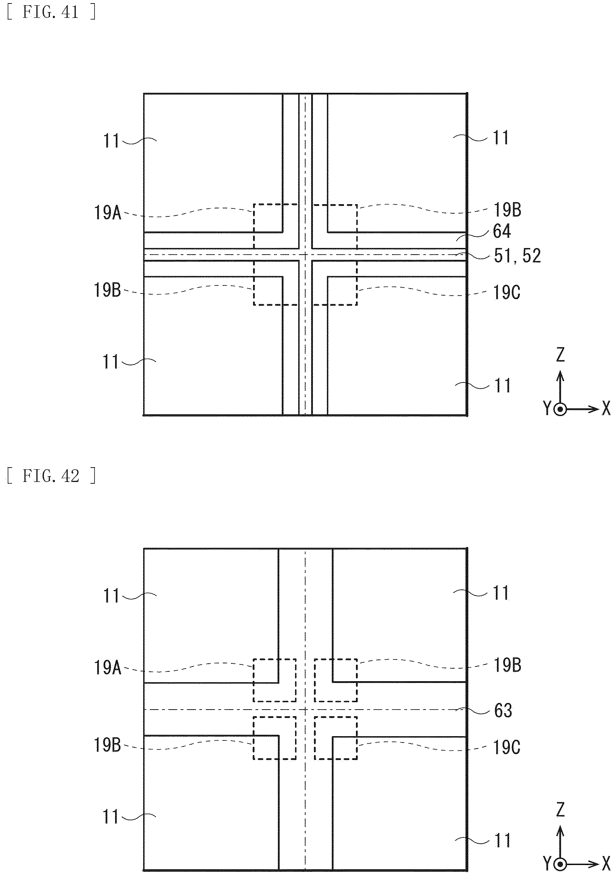

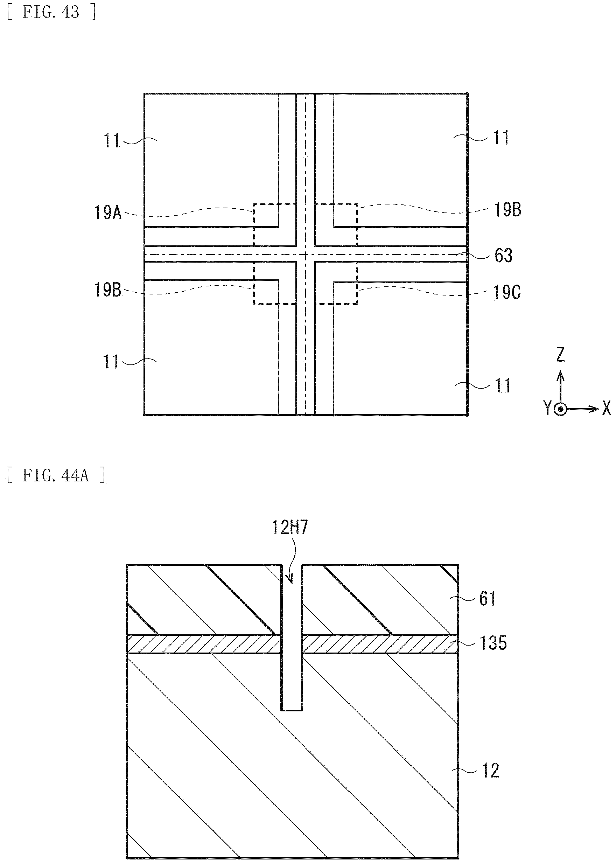

FIG. 40 schematically illustrates an example of a cross-sectional configuration of a photodetector (a photodetector 6A) according to Modification Example 8 of the present disclosure. FIG. 41 is a schematic view of an example of a planar configuration of the photodetector 6 corresponding to a line A-A illustrated in FIG. 40. FIG. 42 is a schematic view of an example of a planar configuration of the photodetector 6 corresponding to a line B-B illustrated in FIG. 40. FIG. 43 is a schematic view of an example of a planar configuration of the photodetector 6 corresponding to a line C-C illustrated in FIG. 40. The photodetector 6A is, for example, a CMOS image sensor, or the like used in an electronic apparatus such as a digital still camera or a video camera, and is a back side illumination photodetector, for example, in the same manner as the foregoing first embodiment.

The foregoing sixth embodiment describes the example in which the element separation section 63 having a substantially trapezoidal shape and having the air gap G therein is provided; however, the shape of the element separation section 63 is not limited thereto. It is sufficient for the element separation section 63 to be wider on the side of the bottoms of the separation sections 51 and 52 than on the side of the surface 10S1 of the semiconductor substrate 10. For example, as illustrated in FIG. 40, the element separation section 63 may have, for example, a substantially T-shaped cross-sectional shape including a vertical part and a horizontal part, and may have a shape in which the air gap G is formed inside the horizontal part.

The element separation section 63 of the present modification example may be formed, for example, as follows.

In the same manner as the foregoing sixth embodiment, first, a groove 12H7 is formed in the silicon nitride film 135 and the silicon oxide film 61 from the side of the surface 10S1 of the semiconductor substrate 10 on which the silicon nitride film 135 and the silicon oxide film 61 are stacked. Thereafter, the groove 12H7 is stretched into the p-well 12 by anisotropic etching, as illustrated in FIG. 44A.

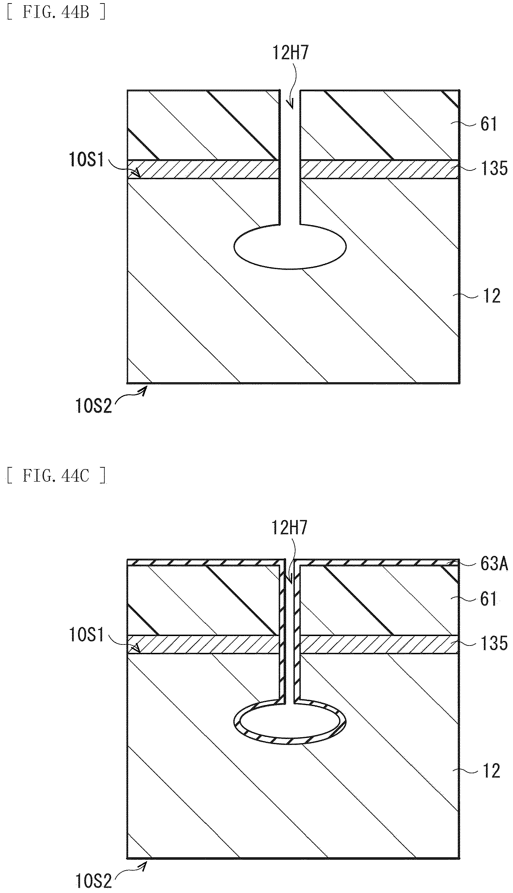

Next, isotropic etching is performed to etch the p-well 12 isotropically, thus forming the groove 12H7, as illustrated in FIG. 44B. Subsequently, as illustrated in FIG. 44C, the silicon oxide film 63A including SiO₂/LP-SiN/SiO₂, for example, is formed on a sidewall of the groove 12H7. Thereafter, in the same manner as the foregoing sixth embodiment, the p-type diffusion region 64 is formed, and then a silicon oxide film is embedded in the groove 12H7 using the ALD method, for example. Thereafter, etch back is performed to remove the silicon oxide film formed on the silicon nitride film 135. This allows for formation of the element separation section 63 having the air gap G therein.

As described above, the cross-sectional shape of the element separation section 63 is not limited to the substantially trapezoidal shape. The wider width of the separation sections 51 and 52 on the side of the bottoms thereof than on the side of the surface 10S1 of the semiconductor substrate 10 makes it possible to obtain effects similar to those of the foregoing sixth embodiment.

### <15. Application Examples>

### (Application Example 1)

In addition, the above-described photodetector (e.g., the photodetector 1) is applicable, for example, to various types of electronic apparatuses including an imaging system such as a digital still camera and a video camera, a mobile phone having an imaging function, or another device having an imaging function.

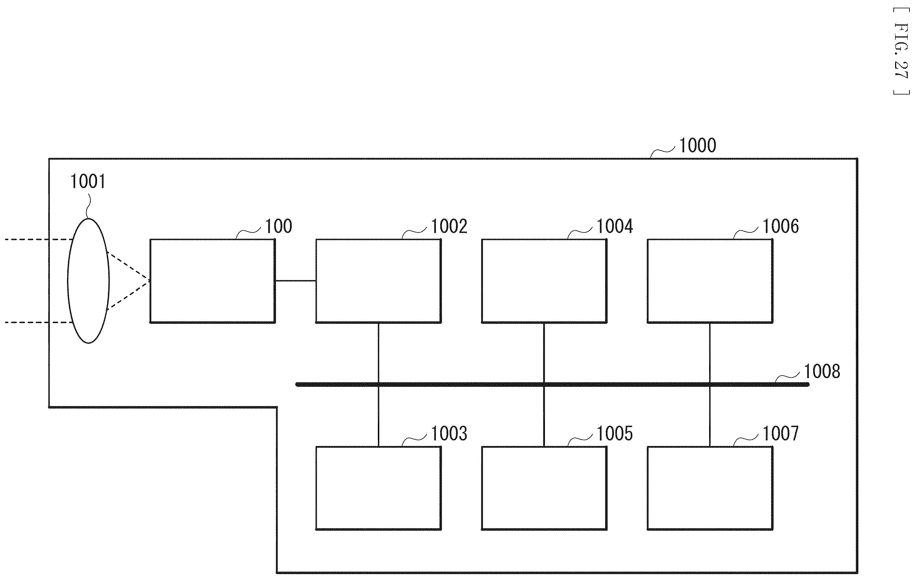

FIG. 27 is a block diagram illustrating an example of a configuration of an electronic apparatus 1000.

As illustrated in FIG. 27, the electronic apparatus 1000 includes an optical system 1001, the photodetector 1, and a DSP (Digital Signal Processor) 1002, and has a configuration in which the DSP 1002, a memory 1003, a display device 1004, a recording device 1005, an operation system 1006, and a power supply system 1007 are coupled together via a bus 1008, thus making it possible to capture a still image and a moving image.

The optical system 1001 includes one or a plurality of lenses, and takes in incident light (image light) from a subject to form an image on an imaging surface of the photodetector 1.

The above-described photodetector 1 is applied as the photodetector 1. The photodetector 1 converts the amount of incident light formed as an image on the imaging surface by the optical system 1001 into electric signals in units of pixels, and supplies the DSP 1002 with the electric signals as pixel signals.

The DSP 1002 performs various types of signal processing on the signals from the photodetector 1 to acquire an image, and causes the memory 1003 to temporarily store data on the image. The image data stored in the memory 1003 is recorded in the recording device 1005, or is supplied to the display device 1004 to display the image. In addition, the operation system 1006 receives various operations by the user, and supplies operation signals to the respective blocks of the electronic apparatus 1000. The power supply system 1007 supplies electric power required to drive the respective blocks of the electronic apparatus 1000.

### (Application Example 2)

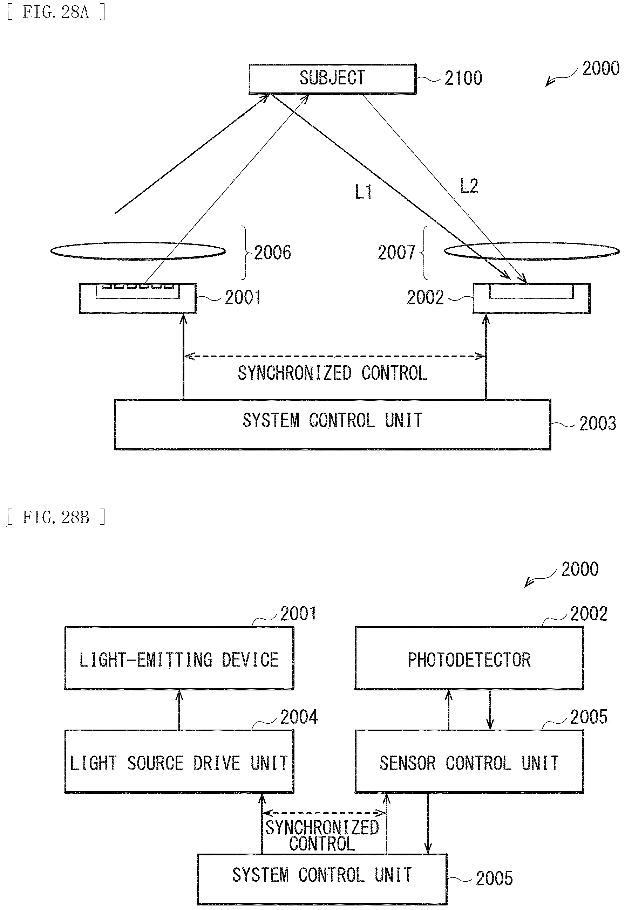

FIG. 28A schematically illustrates an example of an overall configuration of a photodetection system 2000 including the photodetector 1. FIG. 28B illustrates an example of a circuit configuration of the photodetection system 2000. The photodetection system 2000 includes a light-emitting device 2001 as a light source unit that emits infrared light L2 and a photodetector 2002 as a light-receiving unit with a photoelectric conversion element. The above-described photodetector 1 may be used as the photodetector 2002. The photodetection system 2000 may further include a system control unit 2003, a light source drive unit 2004, a sensor control unit 2005, a light source side optical system 2006, and a camera side optical system 2007.

The photodetector 2002 is able to detect light L1 and light L2. The light L1 is reflected light of ambient light from the outside reflected by a subject (measurement target) 2100 (FIG. 28A). The light L2 is light reflected by the subject 2100 after having been emitted by the light-emitting device 2001. The light L1 is, for example, visible light, and the light L2 is, for example, infrared light. The light L1 is detectable at the photoelectric conversion section in the photodetector 2002, and the light L2 is detectable at a photoelectric conversion region in the photodetector 2002. It is possible to acquire image information on the subject 2100 from the light L1 and to acquire information on a distance between the subject 2100 and the photodetection system 2000 from the light L2. For example, the photodetection system 2000 can be mounted on an electronic apparatus such as a smartphone or on a mobile body such as a car. The light-emitting device 2001 can be configured by, for example, a semiconductor laser, a surface-emitting semiconductor laser, or a vertical resonator surface-emitting laser (VCSEL). An iTOF method can be employed as a method for the photodetector 2002 to detect the light L2 emitted from the light-emitting device 2001; however, this is not limitative. In the iTOF method, the photoelectric conversion section is able to measure a distance to the subject 2100 by time of flight of light (Time-of-Flight; TOF), for example. As a method for the photodetector 2002 to detect the light L2 emitted from the light-emitting device 2001, it is possible to adopt, for example, a structured light method or a stereovision method. For example, in the structured light method, light having a predetermined pattern is projected on the subject 2100, and distortion of the pattern is analyzed, thereby making it possible to measure the distance between the photodetection system 2000 and the subject 2100. In addition, in the stereovision method, for example, two or more cameras are used to acquire two or more images of the subject 2100 viewed from two or more different viewpoints, thereby making it possible to measure the distance between the photodetection system 2000 and the subject. It is to be noted that it is possible for the system control unit 2003 to synchronously control the light-emitting device 2001 and the photodetector 2002.

### <16. Practical Application Examples>

### (Example of Practical Application to Endoscopic Surgery System)

The technology according to an embodiment of the present disclosure (present technology) is applicable to various products. For example, the technology according to an embodiment of the present disclosure may be applied to an endoscopic surgery system.

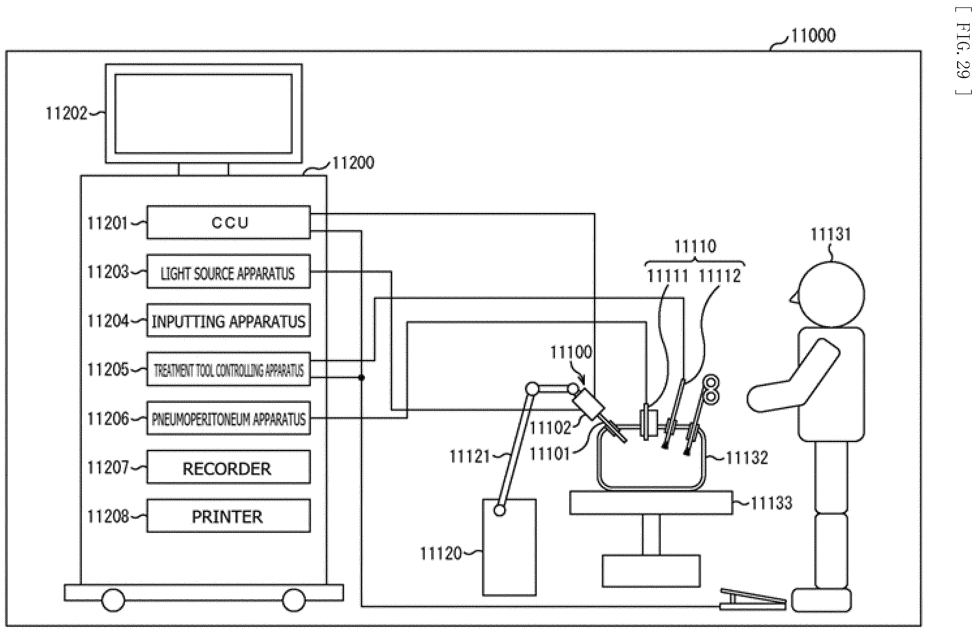

FIG. 29 is a view depicting an example of a schematic configuration of an endoscopic surgery system to which the technology according to an embodiment of the present disclosure (present technology) can be applied.

In FIG. 29, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength region ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

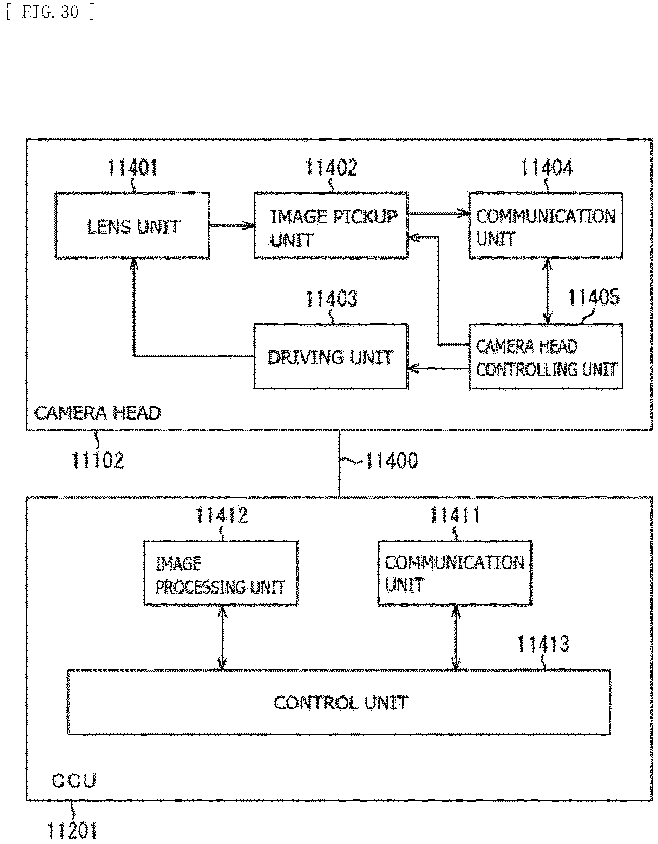

FIG. 30 is a block diagram depicting an example of a functional configuration of the camera head 11102 and the CCU 11201 depicted in FIG. 29.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The description has been given above of one example of the endoscopic surgery system, to which the technology according to an embodiment of the present disclosure is applicable. The technology according to an embodiment of the present disclosure is applicable to, for example, the image pickup unit 11402 of the configurations described above. Applying the technology according to an embodiment of the present disclosure to the image pickup unit 11402 makes it possible to improve detection accuracy.

It is to be noted that although the endoscopic surgery system has been described as an example here, the technology according to an embodiment of the present disclosure may also be applied to, for example, a microscopic surgery system, and the like.

### (Example of Practical Application to Mobile Body)

The technology according to an embodiment of the present disclosure (present technology) is applicable to various products. For example, the technology according to an embodiment of the present disclosure may be achieved in the form of an apparatus to be mounted to a mobile body of any kind. Non-limiting examples of the mobile body may include an automobile, an electric vehicle, a hybrid electric vehicle, a motorcycle, a bicycle, any personal mobility device, an airplane, an unmanned aerial vehicle (drone), a vessel, a robot, a construction machine, and an agricultural machine (tractor).

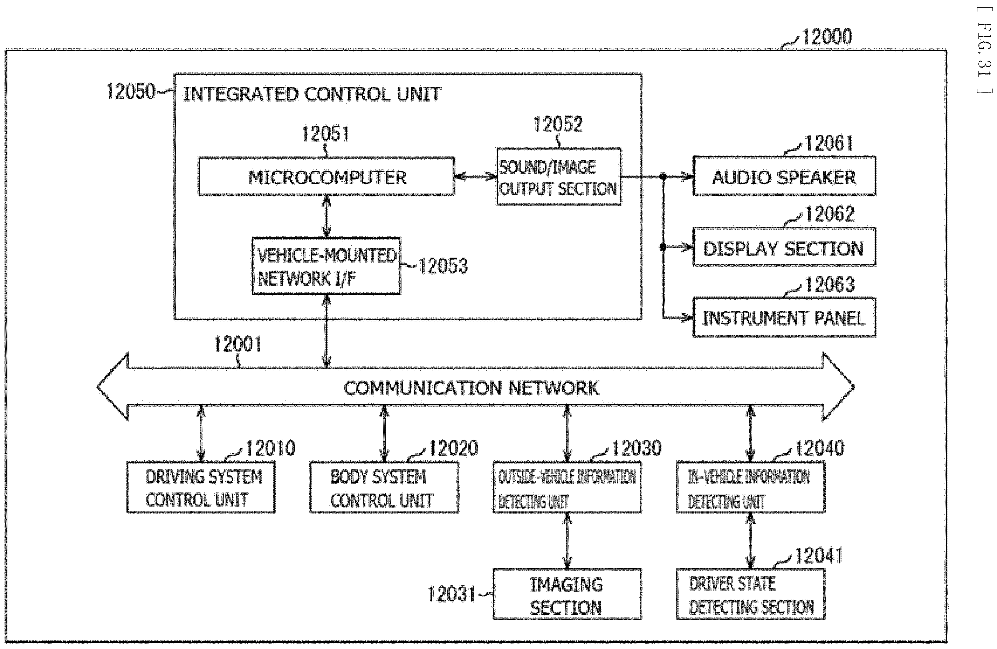

FIG. 31 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 31, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 31, an audio speaker 12061, a display section 12062, and an instrument panel 12063 are illustrated as the output device. The display section 12062 may, for example, include at least one of an on-board display and a head-up display.

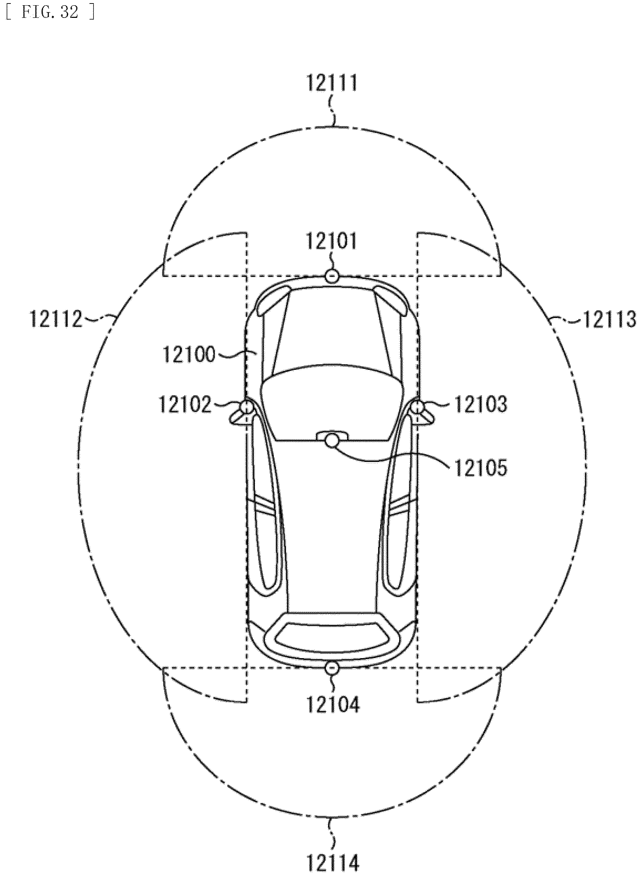

FIG. 32 is a diagram depicting an example of the installation position of the imaging section 12031.

In FIG. 32, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 32 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given hereinabove of one example of the mobile body control system, to which the technology according to an embodiment of the present disclosure may be applied. The technology according to an embodiment of the present disclosure may be applied to the imaging section 12031 among components of the configuration described above. Specifically, the photodetector (e.g., photodetector 1) according to any of the foregoing embodiments and modification examples thereof is applicable to the imaging section 12031. The application of the technology according to an embodiment of the present disclosure to the imaging section 12031 allows for a high-definition captured image with less noise, thus making it possible to perform highly accurate control utilizing the captured image in the mobile body control system.

The description has been given hereinabove of the present disclosure by referring to the first to sixth embodiments, Modification Examples 1 to 8, the application examples, and the practical application examples; however, the present technology is not limited to the foregoing embodiments and the like, and may be modified in a wide variety of ways. For example, the foregoing Modification Examples 1 to 8 may be combined with other embodiments and modification examples as appropriate.

It is to be noted that the effects described herein are merely exemplary and are not limitative, and may further include other effects.

It is to be noted that the present disclosure may also have the following configurations. According to the present technology of the following configurations, it is possible to reduce dispersion of a distance between a floating diffusion layer and a bottom of a second groove part, to reduce pinning on a floating diffusion layer, and to secure an element formation region of a first surface (front surface) of a semiconductor substrate. This makes it possible to improve the performance.
(1) A photodetector including:
   a semiconductor substrate having a first surface and a second surfaces opposed to each other, the semiconductor substrate including a plurality of pixels arranged in matrix;
   a plurality of photoelectric conversion sections formed to be embedded in the semiconductor substrate for the respective pixels and generating electric charge corresponding to a received light amount by photoelectric conversion;
   a plurality of floating diffusion layers provided on the first surface of the semiconductor substrate between the plurality of pixels adjacent to each other, the plurality of floating diffusion layers temporarily holding the electric charge generated in the plurality of photoelectric conversion sections provided for the respective pixels adjacent to each other;
   a first groove part provided to surround the plurality of pixels sharing corresponding one of the floating diffusion layers and penetrating from the first surface of the semiconductor substrate to the second surface;
   a second groove part provided above at least the plurality of floating diffusion layers and stretching from the second surface of the semiconductor substrate toward the first surface, the second groove part having a bottom in the semiconductor substrate; and
   an oxide film provided in contact with the bottom of the second groove part.
(2) The photodetector according to (1), in which the oxide film is provided to have a wider width than a width of the second groove part.
(3) The photodetector according to (1) or (2), in which the oxide film has a function as an etching stopper layer.
(4) The photodetector according to any one of (1) to (3), in which the oxide film includes a silicon carbide film, a silicon oxide film, or a silicon nitride film.
(5) The photodetector according to any one of (1) to (4), in which
   the semiconductor substrate has a p-well on a side of the first surface, and
   the oxide film is provided in the p-well.
(6) The photodetector according to any one of (1) to (5), in which
   the second groove part extends between the plurality of pixels adjacent to each other sharing corresponding one of the floating diffusion layers, and
   the second groove part is in contact with the first groove part on an outer periphery of the plurality of pixels sharing the corresponding one of the floating diffusion layers.
(7) The photodetector according to any one of (1) to (6), in which
   the first groove part extends between the plurality of pixels adjacent to each other sharing corresponding one of the floating diffusion layers from the outer periphery of the plurality of pixels sharing the corresponding one of the floating diffusion layers, and
   the first groove part is in contact with the second groove part provided above the plurality of floating diffusion layers.
(8) The photodetector according to any one of (1) to (7), in which a first pinning film having positive fixed electric charge is formed on an inner wall of each of the first groove part and the second groove part.
(9) The photodetector according to (8), in which the oxide film is formed by a second pinning film having weaker pinning than the first pinning film.
(10) The photodetector according to (9), in which the second pinning film includes a hafnium oxide film.
(11) The photodetector according to (10), in which an insulating film is further embedded in the first groove part and the second groove part.
(12) The photodetector according to (10), in which an electrically-conductive film having a light-blocking property is further embedded in the first groove part and the second groove part.
(13) The photodetector according to any one of (1) to (12), in which a p-type diffusion region is formed along an outer wall of each of the first groove part and the second groove part.
(14) The photodetector according to any one of (1) to (13), in which corresponding one of the floating diffusion layers is disposed near an intersection of four pixels arranged in two rows by two columns, and is shared by the four pixels.
(15) A photodetector including:
   a semiconductor substrate having a first surface and a second surfaces opposed to each other, the semiconductor substrate including a plurality of pixels arranged in matrix;
   a plurality of photoelectric conversion sections formed to be embedded in the semiconductor substrate for the respective pixels and generating electric charge corresponding to a received light amount by photoelectric conversion;
   a plurality of floating diffusion layers provided on the first surface of the semiconductor substrate between the plurality of pixels adjacent to each other, the plurality of floating diffusion layers temporarily holding the electric charge generated in the plurality of photoelectric conversion sections provided for the respective pixels adjacent to each other;
   a first groove part provided to surround the plurality of pixels sharing corresponding one of the floating diffusion layers and penetrating from the first surface of the semiconductor substrate to the second surface, the first groove part having an inner wall on which a first pinning film is formed; and
   a second groove part provided above at least the plurality of floating diffusion layers and stretching from the second surface of the semiconductor substrate toward the first surface, the second groove part having a bottom in the semiconductor substrate and having an inner wall on which a second pinning film is formed, the second pinning film having weaker pinning than the first pinning film.
(16) The photodetector according to (15), in which
   the first groove part extends between the plurality of pixels adjacent to each other sharing corresponding one of the floating diffusion layers from an outer periphery of the plurality of pixels sharing the corresponding one of the floating diffusion layers, and
   the first groove part is in contact with the second groove part provided above the plurality of floating diffusion layers.
(17) A photodetector including:
   a semiconductor substrate having a first surface and a second surfaces opposed to each other, the semiconductor substrate including a plurality of pixels arranged in matrix;
   a plurality of photoelectric conversion sections formed to be embedded in the semiconductor substrate for the respective pixels and generating electric charge corresponding to a received light amount by photoelectric conversion;
   a first separation section provided between the plurality of pixels adjacent to each other and stretching from the second surface of the semiconductor substrate toward the first surface, the first separation section having a bottom in the semiconductor substrate; and
   a second separation section provided between the bottom of the first separation section and the first surface, the second separation section having a wider width on a side of the bottom of the first separation section than on a side of the first surface.
(18) The photodetector according to (17), in which the width of the second separation section on the side of bottom of the first separation section is wider than a width of the first separation section.
(19) The photodetector according to (17) or (18), in which the second separation section has a T-shape.
(20) The photodetector according to any one of (17) to (19), in which the second separation section has therein an air gap.

The present application claims the benefit of Japanese Priority Patent Application JP2022-112817 filed with the Japan Patent Office on July 14, 2022, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A photodetector comprising:
a semiconductor substrate having a first surface and a second surfaces opposed to each other, the semiconductor substrate including a plurality of pixels arranged in matrix;
a plurality of photoelectric conversion sections formed to be embedded in the semiconductor substrate for the respective pixels and generating electric charge corresponding to a received light amount by photoelectric conversion;
a plurality of floating diffusion layers provided on the first surface of the semiconductor substrate between the plurality of pixels adjacent to each other, the plurality of floating diffusion layers temporarily holding the electric charge generated in the plurality of photoelectric conversion sections provided for the respective pixels adjacent to each other;
a first groove part provided to surround the plurality of pixels sharing corresponding one of the floating diffusion layers and penetrating from the first surface of the semiconductor substrate to the second surface;
a second groove part provided above at least the plurality of floating diffusion layers and stretching from the second surface of the semiconductor substrate toward the first surface, the second groove part having a bottom in the semiconductor substrate; and
an oxide film provided in contact with the bottom of the second groove part.

2. The photodetector according to claim 1, wherein the oxide film is provided to have a wider width than a width of the second groove part.

3. The photodetector according to claim 1, wherein the oxide film has a function as an etching stopper layer.

4. The photodetector according to claim 1, wherein the oxide film comprises a silicon carbide film, a silicon oxide film, or a silicon nitride film.

5. The photodetector according to claim 1, wherein
the semiconductor substrate has a p-well on a side of the first surface, and
the oxide film is provided in the p-well.

6. The photodetector according to claim 1, wherein
the second groove part extends between the plurality of pixels adjacent to each other sharing corresponding one of the floating diffusion layers, and
the second groove part is in contact with the first groove part on an outer periphery of the plurality of pixels sharing the corresponding one of the floating diffusion layers.

7. The photodetector according to claim 1, wherein
the first groove part extends between the plurality of pixels adjacent to each other sharing corresponding one of the floating diffusion layers from an outer periphery of the plurality of pixels sharing the corresponding one of the floating diffusion layers, and
the first groove part is in contact with the second groove part provided above the plurality of floating diffusion layers.

8. The photodetector according to claim 1, wherein a first pinning film having positive fixed electric charge is formed on an inner wall of each of the first groove part and the second groove part.

9. The photodetector according to claim 8, wherein the oxide film is formed by a second pinning film having weaker pinning than the first pinning film.

10. The photodetector according to claim 9, wherein the second pinning film comprises a hafnium oxide film.

11. The photodetector according to claim 10, wherein an insulating film is further embedded in the first groove part and the second groove part.

12. The photodetector according to claim 10, wherein an electrically-conductive film having a light-blocking property is further embedded in the first groove part and the second groove part.

13. The photodetector according to claim 1, wherein a p-type diffusion region is formed along an outer wall of each of the first groove part and the second groove part.

14. The photodetector according to claim 1, wherein corresponding one of the floating diffusion layers is disposed near an intersection of four pixels arranged in two rows by two columns, and is shared by the four pixels.

15. A photodetector comprising:
a semiconductor substrate having a first surface and a second surfaces opposed to each other, the semiconductor substrate including a plurality of pixels arranged in matrix;
a plurality of photoelectric conversion sections formed to be embedded in the semiconductor substrate for the respective pixels and generating electric charge corresponding to a received light amount by photoelectric conversion;
a plurality of floating diffusion layers provided on the first surface of the semiconductor substrate between the plurality of pixels adjacent to each other, the plurality of floating diffusion layers temporarily holding the electric charge generated in the plurality of photoelectric conversion sections provided for the respective pixels adjacent to each other;
a first groove part provided to surround the plurality of pixels sharing corresponding one of the floating diffusion layers and penetrating from the first surface of the semiconductor substrate to the second surface, the first groove part having an inner wall on which a first pinning film is formed; and
a second groove part provided above at least the plurality of floating diffusion layers and stretching from the second surface of the semiconductor substrate toward the first surface, the second groove part having a bottom in the semiconductor substrate and having an inner wall on which a second pinning film is formed, the second pinning film having weaker pinning than the first pinning film.

16. The photodetector according to claim 15, wherein
the first groove part extends between the plurality of pixels adjacent to each other sharing corresponding one of the floating diffusion layers from an outer periphery of the plurality of pixels sharing the corresponding one of the floating diffusion layers, and
the first groove part is in contact with the second groove part provided above the plurality of floating diffusion layers.

17. A photodetector comprising:
a semiconductor substrate having a first surface and a second surfaces opposed to each other, the semiconductor substrate including a plurality of pixels arranged in matrix;
a plurality of photoelectric conversion sections formed to be embedded in the semiconductor substrate for the respective pixels and generating electric charge corresponding to a received light amount by photoelectric conversion;
a first separation section provided between the plurality of pixels adjacent to each other and stretching from the second surface of the semiconductor substrate toward the first surface, the first separation section having a bottom in the semiconductor substrate; and
a second separation section provided between the bottom of the first separation section and the first surface, the second separation section having a wider width on a side of the bottom of the first separation section than on a side of the first surface.

18. The photodetector according to claim 17, wherein the width of the second separation section on the side of bottom of the first separation section is wider than a width of the first separation section.

19. The photodetector according to claim 17, wherein the second separation section has a T-shape.

20. The photodetector according to claim 17, wherein the second separation section has therein an air gap.
